**Europäisches Patentamt**

**European Patent Office**

**Office européen des brevets**

(19)

(11) **EP 1 425 665 B1**

(12) **EUROPÄISCHE PATENTSCHRIFT**

(45) Veröffentlichungstag und Bekanntmachung des Hinweises auf die Patenterteilung:
**11.05.2005 Patentblatt 2005/19**

(21) Anmeldenummer: 02703384.4

(22) Anmeldetag: **06.03.2002**

(51) Int Cl.⁷: **G06F 11/10**

(86) Internationale Anmeldenummer:
**PCT/AT2002/000071**

(87) Internationale Veröffentlichungsnummer:
**WO 2002/075545 (26.09.2002 Gazette 2002/39)**

(54) **VERFAHREN UND EINRICHTUNG ZUM TESTEN EINES SPEICHERS**

METHOD AND DEVICE FOR TESTING A MEMORY

PROCEDE ET DISPOSITIF SERVANT A TESTER UNE MEMOIRE

(84) Benannte Vertragsstaaten:
**AT BE CH CY DE DK ES FI FR GB GR IE IT LI LU MC NL PT SE TR**

(30) Priorität: **16.03.2001 AT 4202001**

(43) Veröffentlichungstag der Anmeldung:
**09.06.2004 Patentblatt 2004/24**

(73) Patentinhaber:
• **Thaller, Karl**
  **1200 Wien (AT)**
• **Decomsys - Dependable Computer Systems, Hardware und Software Entwicklung GmbH**
  **1060 Wien (AT)**

(72) Erfinder: **THALLER, Karl**
  **A-1200 Wien (AT)**

(74) Vertreter: **Sonn & Partner Patentanwälte**
  **Riemergasse 14**
  **1010 Wien (AT)**

(56) Entgegenhaltungen:
  **EP-A- 0 614 142**          **US-A- 5 588 112**

**Beschreibung**

Die Erfindung betrifft ein Verfahren zum Testen eines Speichers, wobei gespeicherte Datenwörter mit zugeordneten Prüfbits aus dem Speicher ausgelesen und auf Fehler untersucht werden.

Weiters bezieht sich die Erfindung auf eine Einrichtung zum Testen eines mit einer Zugriffseinheit verbundenen Speichers, mit einer dem Speicher zugeordneten Testeinheit zum Auslesen und Testen von im Speicher gespeicherten Datenwörtern, um etwaige Fehler zu erkennen und gegebenenfalls zu korrigieren.

Mit der Zunahme elektronischer Komponenten und technischer Einrichtungen wird die Sicherheit von Speichern in Steuer- bzw. Rechnereinheiten ein immer wichtigeres Kriterium, so dass das laufende Testen der Speicher derartiger Komponenten, insbesondere von Halbleiter-Speichern bzw. von sog. "embedded memories", immer wichtiger wird. Es gibt Fehler-tolerante Rechnersysteme, die auf der Annahme von Einfach-Fehlern basieren, wobei ein etwaiger Fehler erkannt und beseitigt werden muss, bevor ein zweiter Fehler auftritt. Es wurden demgemäß Techniken zum laufenden Testen von derartigen Speichern entwickelt, vgl. beispielsweise A.J. van de Goor: Testing Semiconductor Memories, Theory and Practice; John Wiley & Sons, 1991, Seiten 93-124; und 397-415; sowie A.J. van de Goor, "Using March Tests to Test SRAMs", IEEE Design & Test of Computers, März 1993, S.8-14; und A.J. van de Goor et al., "Effective March Algorithms for Testing Single-Order Addressed Memories", 4th European Conference on Design Automation, 1993, Proceedings, S.499-505). Die herkömmlichen Testmethoden sind jedoch einerseits keine On-line-Tests, d.h. sie werden nicht während des normalen Systembetriebs durchgeführt (March-Tests, Checkerboard-Test, GALPAT, Walking 1/0, etc.), und sie sehen andererseits nur eine Überprüfung des gerade benötigten Speicherinhalts auf Fehler hin vor und führen keine aktive Fehlersuche durch (Speicher mit Paritätsbit oder anderen Checkbits). Bei beiden bekannten Testmethoden sind Fehlerakkumulationen möglich; bei der ersten, weil der Test nicht On-line durchgeführt wird, bei der zweiten, weil der Test nur den gerade benötigten Speicherinhalt passiv testet; diese Fehlerakkumulationen können unter Umständen schwerwiegende Systemabstürze zur Folge haben. Dadurch sind diese bekannten Testmethoden, auch wenn sie auf erprobte Fehlererkennungs-Algorithmen zurückgreifen, nicht ausreichend sicher und zuverlässig.

Ein anderes Problem ergibt sich beim laufenden Testen eines Speichers während des Betriebs dadurch, dass bei Schreibzugriffen während des Speicher-Tests durch die auf den Speicher zugreifende Einheit Verzögerungen die Folge sind, weil die Adresse jener Speicherzelle, auf die der Schreibzugriff erfolgen soll, jeweils mit der gerade getesteten Speicheradresse verglichen wird. Dieser Adressenvergleich erfordert eine zusätzliche Zeit, die unmittelbar in die Speicherzugriffszeit eingeht. Dagegen gibt die US 5 588 112 ein On-line Testverfahren an, welches bei jedem Speicherzugriff den Daten zugefügte Prüfbits untersucht und gegebenenfalls zur Fehlerkorrektur nutzt. Dabei wird besonderer Wert auf die Trennung normaler Speicherzugriffe und der zur Überprüfung durchgeführten Speicherzugriffe gelegt.

Es ist nun Aufgabe der Erfindung, hier Abhilfe zu schaffen und einen zuverlässigen "transparenten" On-line-Test von Speichern zu ermöglichen, gemäß welchem alle Speicherzellen periodisch und aktiv (d.h. durch Erkennbarmachen latenter Fehler) getestet werden können, ohne dass Schreibzugriffs-Verzögerungen die Folge sind, und wobei gegebenenfalls eine autonome Fehlerkorrektur im Speicher möglich sein soll; durch die mit dem Speicher-Test erzielte frühzeitige Fehlererkennung und gegebenenfalls Fehlerkorrektur sollen darüber hinaus Fehlerakkumulationen verhindert werden. (Unter "transparenter" Test ist dabei zu verstehen, dass der Speichertest ohne wesentliche Beeinflussung des Systems erfolgt.)

Zur Lösung der vorstehenden Aufgabenstellung sieht die Erfindung ein Verfahren sowie eine Einrichtung gemäß den unabhängigen Ansprüchen vor. Vorteilhafte Ausführungsformen und Weiterbildungen sind in den Unteransprüchen angegeben.

Durch den bei der vorliegenden Test-Technik vorgesehenen Adressenvergleich können problemlos zyklische Test-Algorithmen eingesetzt werden, die bekannten March-Algorithmen entsprechen bzw. sich daraus ableiten lassen (beschrieben beispielsweise von A.J. van de Goor: "Testing Semiconductor Memories; Theory and Practice", John Wiley & Sons, 1991, Seiten 106-124); bei jedem Testdurchlauf pro Testzyklus wird der Inhalt der Speicherzellen verändert, nämlich invertiert, und durch den Adressenvergleich kann dann sichergestellt werden, dass im Falle eines Speicherzugriffs (Lesezugriff oder Schreibzugriff der auf den Speicher zugreifenden Einheit) das gespeicherte Datenwort nichtsdestoweniger richtig ausgelesen bzw. ein neues Datenwort richtig eingeschrieben wird. Die an sich durch diesen Adressenvergleich gegebene Zeitverzögerung wirkt sich bei Lesezugriffen praktisch nicht aus, würde jedoch bei Schreibzugriffen eine beträchtliche Verlangsamung zu Folge haben. Um derartige Speicherzugriffs-Verzögerungen im Fall von Schreibzugriffen zu verhindern, wird weiters das jeweilige einzuschreibende Wort gemäß der Erfindung zwischengespeichert und dabei bereits für einen etwaigen unmittelbar danach erfolgenden Lesezugriff auf eben dieses einzuschreibende Datenwort verfügbar gehalten. Dadurch wirkt sich die durch den Adressenvergleich bewirkte zeitliche Verzögerung tatsächlich nicht aus; es ist dabei nur dafür zu sorgen, dass die Adresse jener Speicherzelle, wo das Datenwort einzuschreiben ist, für die auf den Speicher zugreifende Einheit, also in der Regel einen Prozessor, zusammen mit dem Datenwort sofort lesbar wird, wobei der etwaige unmittelbar auf den Schreibzugriff gewünschte Lesezu-

griff vom getesteten Speicher auf das zwischengespeicherte Datenwort - durch Erkennen der fraglichen Adresse - umgeleitet wird. Dies kann durch vorübergehendes "Sperren" der fraglichen Speicherzelle und Auslesen des Datenworts aus dem Zwischenspeicher durch die Testeinheit - die das ausgelesene Datenwort dann dem Prozessor zuführt - erfolgen.

Um diesen unmittelbaren Lesezugriff auch bereits während des Vorganges des Einschreibens des fraglichen Datenworts zu ermöglichen, wird die fragliche Speicherzelle sozusagen vorübergehend "gesperrt", d.h. der Schreibzugriff wird durch den Lesezugriff, der gegenüber dem Schreibzugriff Priorität hat, verzögert und der Schreibzugriff - Datenwort, Schreibadresse und Steuersignale - wird im Zwischenspeicher gehalten. Die Testeinheit führt das Datenwort aus dem Zwischenspeicher dem Prozessor zu.

Diese Zwischenspeicherung von einzuschreibenden Datenwörtern kann auch in vorteilhafter Weise dazu genutzt werden, den Datenwörtern die erforderlichen Prüfbits - je nach Zielvorstellung bei der Prüfung, d.h. Fehlererkennung, und gegebenenfalls Fehlerkorrektur der Inhalte der Speicherzellen - zuzuordnen. Beispielsweise ist es denkbar, jedem Datenwort nur ein Prüfbit zuzuordnen, nämlich das sog. Paritätsbit, so dass eine Paritätsprüfung durchgeführt werden kann. Sofern jedoch eine Fehlerkorrektur ermöglicht bzw. eine fehlerhafte Änderung mehrerer Datenbits innerhalb eines Datenworts erkannt werden soll, können in Anwendung an sich bekannter Techniken einem Datenwort auch mehrere Prüfbits zugeordnet werden, etwa Hamming-Code- oder Hsiao-Code-Prüfbits, um so in an sich bekannter Weise eine Fehlererkennung von Mehrfach-Fehlern und eine Fehlerkorrektur von Einfach-Fehlern oder aber auch Mehrfach-Fehlern pro Datenwort zu ermöglichen.

Dieses Durchtesten des Speichers auf Basis der Prüfbits erfolgt de facto auf einer übergeordneten Ebene. Auf der darunter liegenden Wort-Ebene werden dann die Bits des Datenworts einschließlich Prüfbit(s) gemäß einem Testalgorithmus, insbesondere einem March-Testalgorithmus, getestet.

Die im Speicher enthaltenen Speicherzellen werden auf Wort-Ebene in mehreren Testläufen nacheinander innerhalb eines Testzyklus geprüft. Vor Beginn des Tests auf Wort-Ebene wird das Datenwort ausgelesen, mit Hilfe der Prüfbits auf Fehler überprüft und dann in einem Register zwischengespeichert. Sodann beginnt der Test auf Wort-Ebene, wobei das Datenwort gegebenenfalls mehrmals verändert in den Speicher zurückgeschrieben, wieder ausgelesen und das gelesene Datenwort mit den Schreibdaten verglichen wird. Am Ende dieses Tests auf Wort-Ebene liegt das Datenwort im Speicher in invertierter Form vor. Durch diese Vorgangsweise, die als aktiver Fehlertest bezeichnet wird, werden sog. latente Fehler erkennbar gemacht und im selben oder in den darauffolgenden Testläufen erkannt. Die Fehlererkennungsrate wird dadurch wesentlich erhöht. Dabei ist es auch für die Fehlererkennung vorteilhaft, wenn pro Testzyklus zwei aufeinanderfolgende Testläufe in einer Richtung mit aufsteigender Adressenreihenfolge und die zwei nachfolgenden Testläufe gemäß einer absteigenden Adressenreihenfolge durchgeführt werden, wobei mit aufsteigender bzw. absteigender Adressenreihenfolge keine inkrementellen bzw. dekrementellen Adressenreihenfolgen gemeint sind, sondern es sich bei der absteigenden Adressenreihenfolge lediglich um die exakte Umkehrung der aufsteigenden handelt. Für jeden Testlauf werden dabei am Ende des Tests auf Wort-Ebene zweckmäßigerweise die einzelnen Bits wieder in invertierter Form in die Speicherzellen zurückgeschrieben; im Falle eines Schreibzugriffs durch die auf den Speicher zugreifende Einheit wird das einzuschreibende Datenwort (samt Prüfbits) in entsprechender Weise invertiert in die adressierte Speicherzelle eingeschrieben, wenn diese Speicheradresse in einem Adressenbereich liegt, wo die Inhalte der Speicherzellen durch den gerade in Gang befindlichen Testlauf bereits in einer invertierten Form vorliegen.

Um die Fehlererkennungsrate im Fall von miteinander wechselwirkenden Fehlern (sog. linked faults) zu verbessern, werden vorteilhaft auch nach jedem Testzyklus die Startadresse für den nächsten Testzyklus und die Testadressen-Reihenfolge variiert. Dabei kann die Startadresse einfach durch einen Zähler oder durch einen Zufallsgenerator erzeugt werden. Ein solcher Zufallsgenerator müsste jedoch für unterschiedliche Speichergrößen jeweils verschieden ausgelegt werden; andererseits würde im Falle einer inkrementellen Startadressen-Folge eine zu lange Zeit benötigt werden, um innerhalb des Adressenbereichs signifikante Startadressen-Änderungen zu erreichen. Zur Erzielung von unmittelbaren wesentlichen Startadressen-Änderungen wird daher mit Vorteil aus der inkrementellen Startadressen-Reihenfolge eine Gray-codierte Startadressen-Reihenfolge erzeugt und diese vom niederwertigsten zum höchstwertigen Bit (vom LSB zu MSB) hin gelesen und verwendet. Dadurch können ausreichend große Sprünge bei der Startadressen-Variation erzielt werden, wobei eine Adaption an unterschiedliche Speichergrößen vorteilhafterweise nicht erforderlich ist. Innerhalb eines Testzyklus werden jedoch die Testläufe zweckmäßig bei derselben Startadresse begonnen (bei aufsteigender Adressenreihenfolge) bzw. beendet (bei absteigender Adressenreihenfolge).

Die Variation der Testadressen-Reihenfolge wird durch Rotation der ursprünglichen inkrementellen bzw. dekrementellen Adressenreihenfolge um eine variable Anzahl von Bits bewerkstelligt. Diese Rotation der Adressenreihenfolge ist auch wesentlich für die Erkennung von sog. SOADF-(Stuck-open-Adressendekoder)-Fehlern.

Der Zwischenspeicher bzw. die beiden Zwischenspeicher-Stufen kann bzw. können auf einfache Weise, insbesondere durch ein einfaches Register, gebildet werden. Zum Hinzufügen der Prüfbits wird dem Zwischenspeicher ein Prüfbitgenerator zugeordnet, welcher zweckmäßig im Datenpfad zwischen den beiden Zwischenspeicher-Stufen angeordnet wird. Dieser Prüfbitgenerator erzeugt die Prüfbits je nach Datenwort (Parität, Hamming-Code etc.) in an sich bekannter Weise.

Die Testeinheit zur Durchführung des transparenten On-line-Speichertests ist zweckmäßigerweise eine Hardware-Ausführung, spezifiziert in einer Hardware-Beschreibungssprache, und enthält einen Testkontrollblock, der eine Testlauf-Zustandsmaschine für mehrere Testläufe pro Testzyklus, eine Fehlertest-Zustandsmaschine für die Durchführung des Fehlererkennungstests gemäß einem der fest eingegebenen Algorithmen, sowie eine Fehlerbehandlungs-Zustandsmaschine vorsieht. Die Fehlerbehandlungs-Zustandsmaschine steuert das Verhalten der Testeinheit im Fall einer Fehlererkennung. Dabei kann zwischen korrigierbaren und nicht-korrigierbaren Fehlern unterschieden werden, und weiters kann auch zwischen sog. Soft-Fehlern und Hard-Fehlern im Speicher unterschieden werden. Im Falle eines "Soft"-Speicherfehlers genügt es, einfach die korrigierten Daten in die Zelle zurückzuschreiben. Wenn danach neuerlich ein Fehler bei dieser Speicherzelle festgestellt wird, dann liegt ein sog. "Hard"-Fehler (Dauerfehler) vor.

Um zu erkennen, ob das jeweils einzuschreibende Datenwort samt Prüfbit(s) in der ursprünglichen Form oder in invertierter Form in die gewünschte Speicherzelle einzuschreiben ist, wird der vorstehend angesprochene Adressenvergleich durchgeführt. Das jeweilige Datenwort wird einerseits durch einen Inverter und andererseits über einen zu diesem parallel geschalteten Weg einem Multiplexer zugeführt, welcher entsprechend einem ihm weiters zugeführten, auf Grund des Adressenvergleichs erzeugten Steuersignal das Datenwort samt Prüfbit(s) entweder in der invertierten Form oder aber in der ursprünglichen Form dem Speicher zuführt.

Um während eines Tests des Speichers die Adressen der zu prüfenden Speicherzellen laufend zu erzeugen, kann die Testeinheit einen Testadressen-Generator mit einer Startbit-Erzeugungsstufe und mit einem Testadressen-Zähler enthalten. Dieser Testadressen-Generator ist mit seinem Ausgang an den Eingang eines Adressen-Komparators gelegt, dem auch die etwaigen Zugriffsadressen zugeführt werden. Die Startbit-Erzeugungsstufe erzeugt zusammen mit dem Testadressen-Zähler aus einer Startadressen-Reihenfolge die zuvor bereits angesprochene Gray-codierte rückwärts gelesene Startadressen-Reihenfolge.

Eine weitere Verbesserung der Fehlererkennungsrate und die Erkennung der Stuck-open-Adressendekoder-Fehler wird durch Implementierung von sog. Rotier-Einheiten erreicht. Die erste Rotier-Einheit erzeugt aus einer inkrementell aufsteigenden bzw. einer dekrementell absteigenden Adressenreihenfolge eine um eine bestimmte Anzahl von Bits rotierte Adressenreihenfolge. Die zweite Rotier-Einheit rotiert die Zugriffsadressen bei einem Speicherzugriff der auf den Speicher zugreifenden Einheit um die selbe Anzahl von Bits in die entgegengesetzte Richtung zurück und ermöglicht damit den oben beschriebenen Adressenvergleich zur Bestimmung der entsprechenden Darstellungsweise des Datenwortes.

Von Vorteil ist es auch, wenn im Falle eines Paritäts-Prüfbits nach erfolgtem Test auf Wort-Ebene jeweils die Interpretation des Paritäts-Prüfbits geändert wird, wobei von ungerader Parität auf gerade Parität und umgekehrt gewechselt wird; bzw. wenn im Falle von Hamming-Code-Prüfbits nach erfolgtem Test auf Wort-Ebene jeweils die Interpretation der Hamming-Code-Prüfbits geändert wird, wobei für eine gerade Anzahl von Bits, über die ein Hamming-Code-Prüfbit berechnet wird, von ungerader auf gerade Parität und umgekehrt gewechselt wird, wogegen für eine ungerade Anzahl von Bits, über die ein Hamming-Code-Prüfbit berechnet wird, die Interpretation unverändert bleibt.

Im Falle der Zuordnung von Fehlerkorrektur-Prüfbits enthält zweckmäßig die Testeinheit auch eine Fehlerkorrektur-Einheit.

Die Erfindung wird nachfolgend anhand von in der Zeichnung veranschaulichten bevorzugten Ausführungsbeispielen, auf die sie jedoch nicht beschränkt sein soll, noch weiter erläutert. Es zeigen:

Fig.1 eine schematische Anordnung einer Einrichtung zum On-line-Testen eines Speichers, wobei ein Prozessor als Speicherzugriffseinheit veranschaulicht ist;

Fig.2 schematisch eine Anordnung mit der Testeinrichtung und dem Speicher, wobei die Funk tion eines Testadressen-Zeigers und eines Adressen-Komparators veranschaulicht ist;

Fig.3 schematisch die Zuordnung eines Zwischenspeichers, einer sog. "Pipeline", zur Testeinheit zwischen Prozessor und Speicher;

Fig.4 in einem Blockschaltbild eine Testeinrichtung mit der eigentlichen Testeinheit und der Pipeline gemäß Fig.3 in Form von zwei Zwischenspeicher-Stufen;

Fig.5 ein Schema (Fig.5A) sowie ein Diagramm zur Veranschaulichung der Zugriffszeit im Fall einer Testeinrichtung mit Pipeline (Fig.5B) und ohne Pipeline (Fig.5C);

Fig.6 schematisch in einem Blockschaltbild den Aufbau der Testeinheit;

Fig.7 schematisch in einem Blockschaltbild den Aufbau eines Registerblocks dieser Testeinheit gemäß Fig.6;

Fig.8 den Aufbau eines Testadressen-Generators und Adressenkomparators innerhalb dieser Testeinheit;

Fig.9 schematisch den Aufbau eines Testdaten-Generators und Daten-Komparators der Testeinheit;

Fig.10 ein Testzyklus-Schema;

Fig.11 in einem Zustandsdiagramm eine Veranschaulichung der Testlauf-Zustandsmaschine, die in der Testeinheit realisiert ist;

die Figuren 12 bis 14 drei Fehlertest-Zustandsmaschinen in entsprechenden Zustandsdiagrammen; und

Fig.15 eine Fehlerbehandlungs-Zustandsmaschine der Testeinheit in einem Zustandsdiagramm.

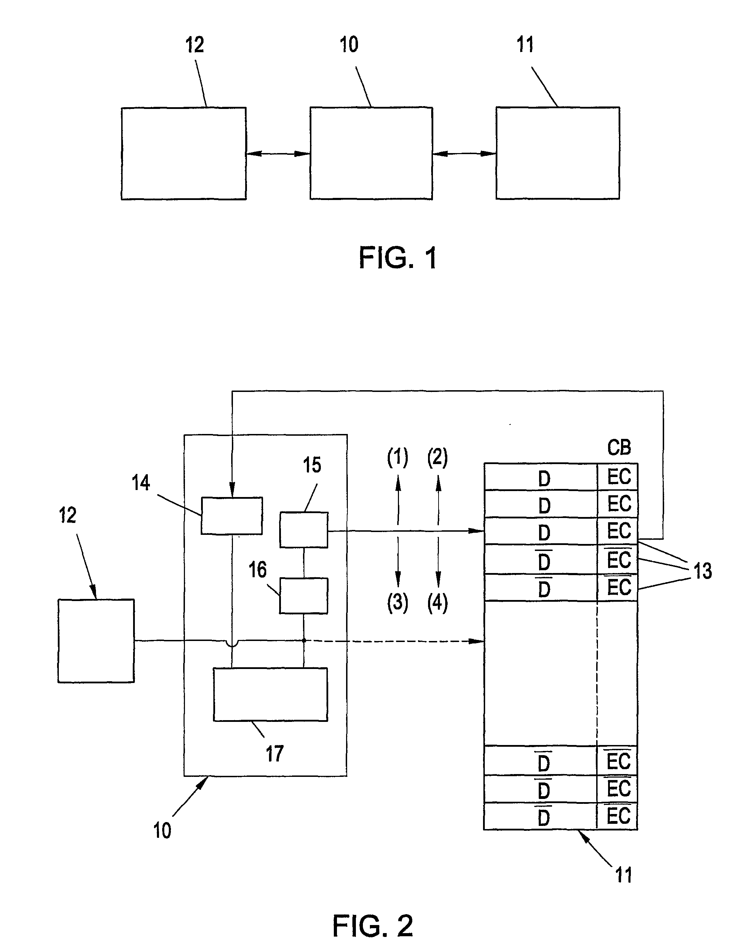

Gemäß Fig.1 wird die vorliegende Einrichtung 10 zum On-line-Testen eines Speichers 11 zwischen diesem Speicher 11 und einer auf den Speicher 11 zugreifenden Einheit, in der Regel einem Prozessor 12, angeordnet. Diese Konfiguration kann jedoch geändert werden, wenn die Test-Einrichtung 10 zum Einsatz als reine Fertigungs-Testeinheit vorgesehen wird, wobei dann direkte Busverbindungen (in einer Stern-Konfiguration) zwischen dem Speicher 11, der Test-Einrichtung 10 und dem Prozessor 12 vorgesehen werden.

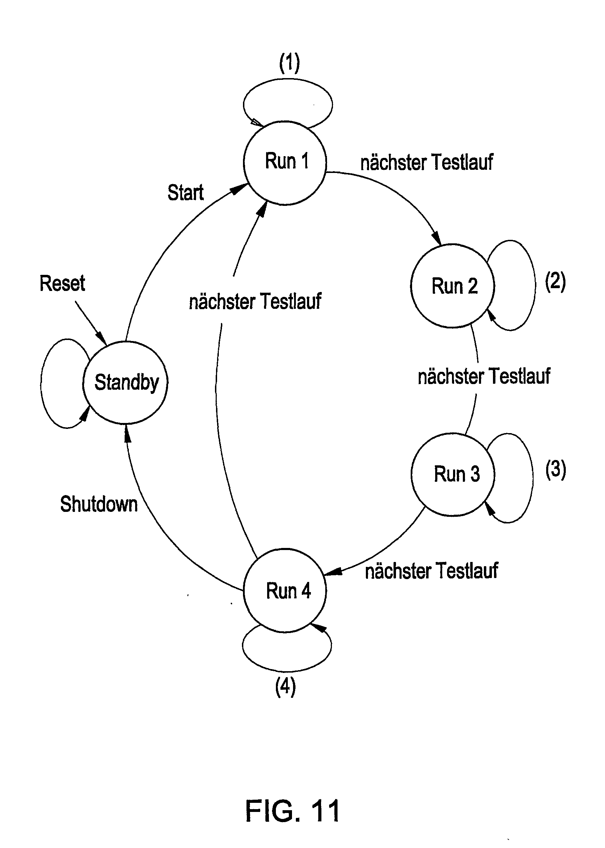

In Fig.2 ist schematisch der Speicher 11 mit einer Vielzahl von Speicherzellen 13, je mit einem Speicherteil für Datenbits D und einem Speicherteil für Prüfbits CB (CB-check bit), ausgebildet. Die Test-Einrichtung 10 überstreicht beim Testen den gesamten Speicher 11, d.h. alle Speicherzellen 13, wobei sie laufend die Speicherzellen 13 gemäß intern erzeugten Testadressen adressiert und die jeweiligen Daten-Inhalte dieser Speicherzellen 13, d.h. Daten D, samt den zugehörigen Prüfbits - die in den einzelnen Zeilen von Fig.2 mit "EC" (error check-Fehlerprüfung) bezeichnet sind - ausliest und aufeinanderfolgend in einem Backup-Register 14 vorübergehend speichert. Die Adresse der jeweils gerade getesteten Speicherzelle 13 wird in einem Testadressen-Zeiger 15 festgehalten, und diese Testadresse wird gegebenenfalls in einem nachfolgend noch näher zu beschreibenden Adressen-Komparator 16 mit einer vom Prozessor 12 im Falle eines gewünschten Speicherzugriffs zugeführten Zugriffsadresse verglichen. Der Grund hiefür ist, dass die Speicherzellen 13 zyklisch in jeweils vier Testläufen (1), (2), (3) und (4) pro Testzyklus getestet werden, wobei die Daten D in den Speicherzellen 13 ebenso wie die Prüfbits EC bei jedem Testdurchlauf verändert werden, insbesondere im Vergleich zum vorherigen Zustand invertiert werden, wie dies bei Anwendung des oben erwähnten Tests auf Wort-Ebene vorgesehen ist. In Fig.2 ist dies schematisch dadurch veranschaulicht, dass in jenen Speicherzellen 13, die unterhalb der Speicherzelle 13 liegen, auf die der Testadressen-Zeiger 15 zeigt, (beim gerade durchgeführten Testlauf mit aufsteigender Adressenreihenfolge), die Daten D und Prüfbits EC bereits invertiert (also mit $\overline{D}$ bzw. $\overline{EC}$) dargestellt'sind, oberhalb und innerhalb dieser Speicherzelle 13, auf die der Testadressen-Zeiger zeigt, die Daten D und Prüfbits EC jedoch noch nicht invertiert veranschaulicht sind. (Beim unmittelbar darauffolgenden Testlauf (2), wo ebenfalls jeweils der Speicherzelleninhalt invertiert wird, wird somit der nicht-invertierte Zustand der Daten und Prüfbits wieder hergestellt, vgl. auch Fig.10).

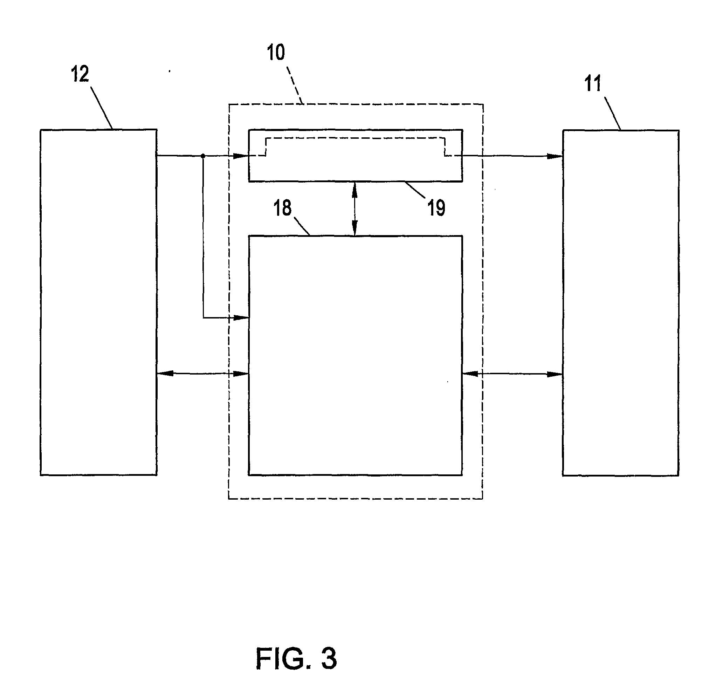

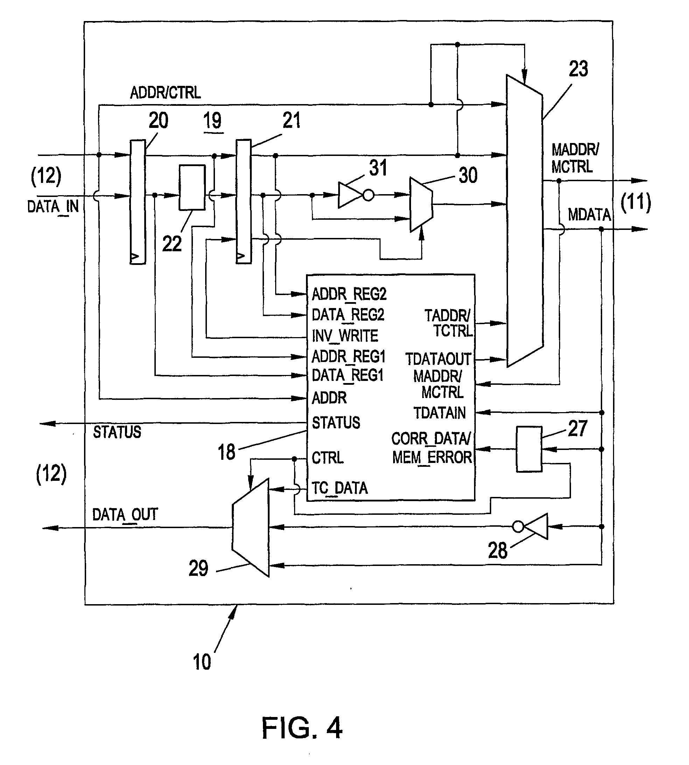

Schematisch ist schließlich in Fig.2 noch ganz allgemein eine Fehlererkennungs- und -korrektur-Vorrichtung 17 veranschaulicht, die Teil der eigentlichen Testeinheit 18 ist, die in Fig.3 und 4 näher veranschaulicht ist. Zu dieser Testeinheit 18 gehört auch der Adressen-Komparator 16, ebenso wie das Backup-Register 14 und der Testadressen-Zeiger 15, auch wenn diese Komponenten in Fig.2 zwecks besserer Veranschaulichung gesondert gezeichnet wurden.

Aus Fig.3 ist ersichtlich, dass innerhalb der Test-Einrichtung 10 der eigentlichen Testeinheit 18 eine Zwischenspeicher-Einheit 19, nachfolgend auch "Pipeline" genannt, zugeordnet ist. Mit dieser Pipeline 19 werden Speicherzugriffs-Verzögerungen für Schreibzugriffe praktisch nicht mehr merkbar. Für Lesezugriffe ergibt sich durch die für den Fehlertest benötigte Zeit eine bloß geringfügige Verzögerung, so dass eine derartige Pipeline 19, wie sie nachfolgend anhand der Fig.4 noch näher beschrieben wird, für Lesezugriffe nicht erforderlich ist.

Gemäß Fig.4 ist die Pipeline 19 mit einer ersten Zwischenspeicher-Stufe 20 und einer zweiten Zwischenspeicher-Stufe 21, je in Form eines einfachen Registers, aufgebaut. Zwischen den beiden Registern 20, 21 ist im Datenweg ein Prüfbitgenerator 22 angeordnet, der den zugeführten Datenwörtern (am Eingang DATA_IN) die je nach Konfiguration der Testeinheit 18 erforderlichen Prüfbits, wie z.B. Paritätsbit, aber auch Hamming-Code-Prüfbits oder Hsiao-Prüfbits, hinzufügt. Die Datenwörter D werden dann zusammen mit diesen Prüfbits P in den Speicher 11 eingeschrieben.

Bei derartigen Speicherzugriffen werden die Zugriffsadressen (Bus ADDR/CTRL) außer dem ersten Register 20 auch der Testeinheit 18 zugeführt (s. deren Eingang ADDR), und ebenso werden sie an einen Multiplexer 23 angelegt, der die Zugriffsadressen im Falle eines Lesezugriffs zum Speicher durchschaltet, wobei die Pipeline 19 umgangen wird. Wie weiters aus Fig.4 ersichtlich ist, werden im Falle eines Schreibzugriffs die vom Prozessor 12 zugeführten Adressen am Ausgang des ersten Registers 20 (s. Eingang ADDR-REG1 der Testeinheit 18) ebenso wie am Ausgang des zweiten Registers 21 (s. Eingang ADDR-REG2 der Testeinheit 18) an die Testeinheit 18 angelegt; ferner werden die Daten am Ausgang des ersten Registers 20 wie jene am Ausgang des zweiten Registers 21 der Testeinheit 18 zugeführt, vgl. deren Eingänge DATA_REG1 und DATA_REG2.

Auf diese Weise ist im Falle eines Lesezugriffs (s. Adressbus zum Eingang ADDR der Testeinheit 18) ebenso wie im Fall eines Schreibzugriffs (s. Adressbus zu den Eingängen ADDR_REG1 und ADDR_REG2) die jeweilige Zugriffsadresse in der Testeinheit 18 für einen Adressenvergleich verfügbar. Weiters sind auch die Daten, wie sie im ersten Register 20 und im zweiten Register 21 zwischengespeichert sind, in der Testeinheit 18 verfügbar, und im Falle, dass ein Schreibzugriff vom Prozessor 12 gewünscht wird, kann nun ein derartiger Adressenvergleich erfolgen, während die Daten im ersten Register 20 zwischengespeichert und so verfügbar sind; für den Fall eines unmittelbar folgenden Lesezugriffs auf eben diese Daten, mit derselben Adresse, können diese Daten über die Testeinheit 18 als "auszulesende Daten" - aufgrund des Adressenvergleichs - erkannt werden und dem Prozessor 12 zugeleitet werden, bevor noch der tatsächliche Einschreibvorgang erfolgt ist.

Für diesen Einschreibvorgang werden die Daten sodann unter Steuerung eines Taktsignals in der zweiten Zwischenspeicher-Stufe, d.h. im zweiten Register 21, gespeichert und verfügbar gehalten, wobei sie auch hier für einen etwaigen unmittelbaren Lesezugriff für die Testeinheit 18 zur Verfügung stehen.

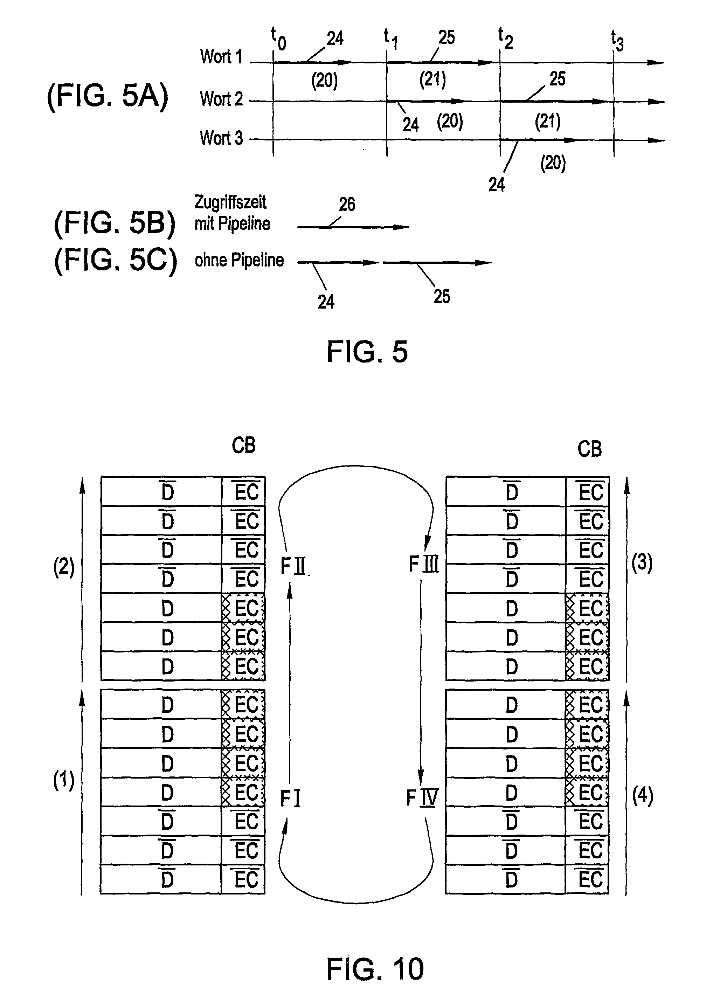

Durch diese Aufteilung der ansonsten hintereinander durchzuführenden Operationen des Adressenvergleichs und des Einschreibens der Daten wird es ermöglicht, die Zugriffszeit für Schreibzugriffe im Vergleich zu einer Situation ohne derartige Pipeline 19 zu verkürzen. Wie aus Fig.5 ersichtlich ist, wäre nämlich im Fall ohne Pipeline 19 die durch einen Pfeil 24 mit vorgegebener Länge veranschaulichte Zeit für einen Adressenvergleich zusammen mit der durch einen Pfeil 25 veranschaulichten Zeit für das Einschreiben, d.h. Abspeichern eines Datenworts im Speicher, anzusetzen. Durch Vorsehen der Pipeline 19 wird die Zugriffszeit auf eine Zykluszeit $t_0$-$t_1$, $t_1$-$t_2$ usw. verkürzt (s. Pfeil 26 in Fig. 5B), ausgehend von der Gesamtzeit gemäß Pfeil 24 plus Pfeil 25 (Fig.5C). Es wird also die Zugriffszeit auf jene Zeit verkürzt, die für die längere der beiden Operationen benötigt wird, also im vorliegenden Beispiel auf die Zeit für das Einschreiben der Datenwörter. Ohne die Pipeline 19 müsste die Zugriffszeit um die Zeit für den Adressenvergleich (Pfeil 24) verlängert werden. Außerdem wird durch die Zwischenspeicherung in der Pipeline 19 eine Parallelisierung der Schreibzugriffe ermöglicht, wie dies ebenfalls im Schema von Fig.5A mit den Datenwörtern "Wort 1", "Wort 2" und "Wort 3" veranschaulicht ist. Ein weiterer Schreibzugriff kann nämlich bereits im unmittelbar auf den ersten Schreibzugriff folgenden Taktzyklus, also beispielsweise in der Zeit $t_1$-$t_2$, erfolgen; das Datenwort "Wort 1" gemäß dem vorhergehenden Schreibzugriff befindet sich zu diesem Zeitpunkt im zweiten Register 21.

Insgesamt ist dabei die Verzögerung durch den Adressenvergleich für den Prozessor 12 transparent, d.h. der Prozessor 12 wird durch den Adressenvergleich tatsächlich nicht beeinflusst.

Gemäß Fig.4 ist der Testeinheit 18 weiters eine Fehlerprüfeinheit 27 zugeordnet, die aus dem Speicher 11 ausgelesene Daten (MDATA) zugeführt erhält und aufgrund der zugehörigen Prüfbits beispielsweise auf Parität bzw. allgemein auf Fehler überprüft und gegebenenfalls Fehler aufgrund von Fehlerkorrekturcodes korrigiert. Diese Fehlerprüfeinheit 27 leitet die (gegebenenfalls korrigierten) Daten bzw. ein etwaiges Fehlersignal (Eingang CORR_DATA/ MEM_ERROR) der Testeinheit 18 zu, damit diese korrigierten Daten von der Testeinheit 18 einerseits an den Prozessor 12 über den Ausgang TC_DATA weitergeleitet werden und andererseits gegebenenfalls zur Fehlerkorrektur von Soft-Fehlern im Speicher 11 weiterverwendet, d.h. in den Speicher 11 über die Signale TADDR/TCTRL und TDATAOUT zurückgeschrieben werden.

Die aus dem Speicher 11 ausgelesenen Daten MDATA werden weiters direkt sowie über einen Inverter 28 an einen Multiplexer 29 gelegt, der überdies auch im Falle eines korrigierbaren Fehlers die korrigierten Daten (Ausgang TC_DATA der Testeinheit 18) zugeführt erhält und auf ein Steuersignal hin (s. Steuerausgang CTRL) die jeweiligen Daten (Originaldaten, invertierte Daten oder korrigierte Daten) über den Ausgang DATA_OUT dem Prozessor 12 zuleitet.

Innerhalb der Testeinheit 18 erfolgt wie bereits erwähnt ein Adressenvergleich, um im Falle eines Speicherzugriffs durch den Prozessor 12 die Zugriffsadresse mit der Testadresse, d.h. der Adresse der gerade getesteten Speicherzelle 13, zu vergleichen und abhängig vom Vergleichsergebnis den Speicherzugriff zu behandeln. Da wie erwähnt beim Test auf Wort-Ebene in jedem Testlauf (1) bis (4) die Bits in den Speicherzellen 13 (einschließlich Prüfbits) invertiert werden, kann aufgrund dieses Adressenvergleichs nicht nur der Ausgangs-Multiplexer 29 entsprechend angesteuert werden, um im Falle des Auslesens einer Speicherzelle 13 mit invertierten Bits gegebenenfalls die Daten mit einer neuerlichen Invertierung (Inverter 28) weiterzuleiten, sondern auch, um im Falle eines Schreibzugriffs über die Pipeline 19 in dem Adressenbereich des Speichers 11 mit bereits invertierten Bits eine Abspeicherung der neuen Daten (Datenwort D, Prüfbits EC) in invertierter Form vorzunehmen. Zu diesem Zweck gibt die Testeinheit 18 am Steuerausgang INV_WRITE ein die Weiterleitung in invertierter Form veranlassendes Steuersignal über das zweite Register 21 an einen als Steuergatter vorgesehenen Multiplexer 30 ab, der an seinen Eingängen die jeweiligen Datenwörter nicht invertiert bzw. mit Hilfe eines Inverters 31 invertiert zugeführt erhält, und der je nach Ansteuerung diese Daten in invertierter oder nicht-invertierter Form an den Steuergatter-Multiplexer 23 weiterleitet. Durch die Zuleitung des Steuersignals INV_WRITE an den Multiplexer 30 über das zweite Register 21 wird sichergestellt, dass bei einem längeren Gespeicherthalten des jeweiligen Datenworts im zweiten Register 21, wenn nämlich unmittelbar auf den Schreibzugriff mehrere Lesezugriffe erfolgen, die eine höhere Priorität haben und daher vorrangig behandelt werden, das Steuersignal INV_WRITE ebenfalls gespeichert gehalten und schließlich zusammen mit dem zugehörigen Datenwort an den Multiplexer 30 weitergeleitet wird.

Schließlich ist aus Fig.4 noch zu ersehen, dass die Testeinheit 18 an den Ausgängen TADDR/TCTRL sowie TDATAOUT im Normalfall die entsprechenden Adress- und Steuersignale sowie Datensignale für den gerade durchzuführenden Test auf Wort-Ebene an den Multiplexer 23 und über diesen an den Speicher 11 abgibt, und gegebenenfalls bei einer Soft-Fehler-Korrektur die korrigierten Daten über diese Signale in den Speicher zurückschreibt und mit Hilfe der Adress- und Steuersignale wieder ausliest. Weiters wird über einen STATUS-Ausgang eine Zustandsmeldung an den Prozessor 12 abgegeben, z.B. wenn eine Fehlermeldung erfolgen soll.

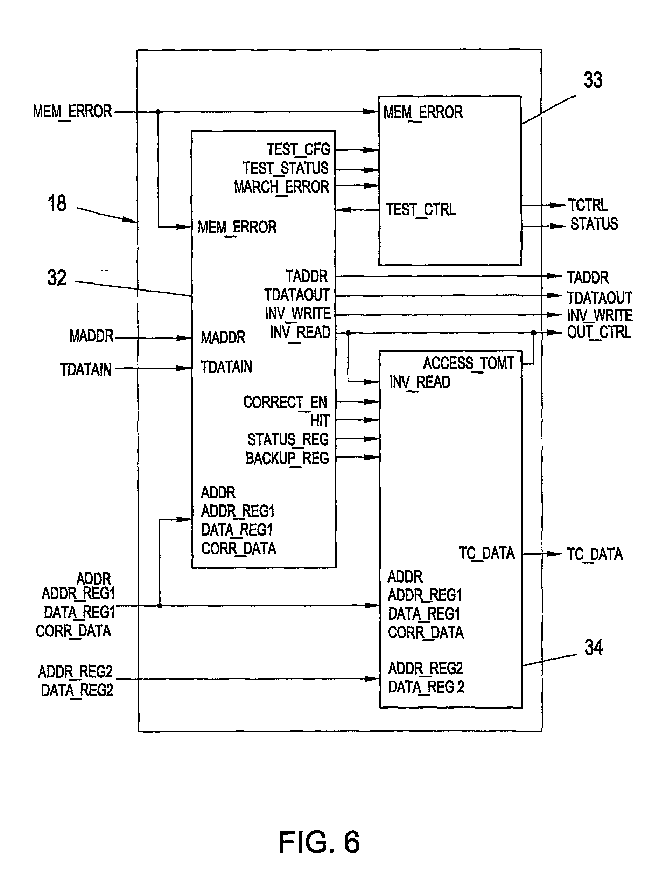

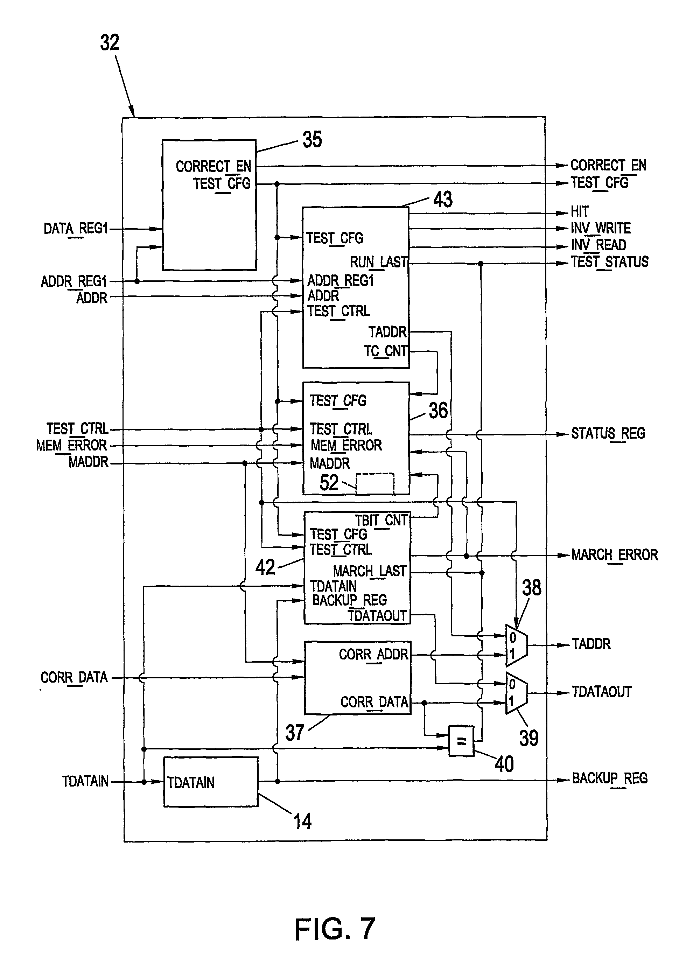

In Fig.6 ist der prinzipielle Aufbau der Testeinheit 18 mit einem Registerblock 32, einem Testkontrollblock 33 und einem Lesemultiplexer 34 veranschaulicht. Der Registerblock 32, der nachfolgend anhand der Fig.7 noch näher erläutert werden wird, enthält unter anderem die für den jeweils durchzuführenden Test erforderlichen Konfigurationsdaten, s. den Ausgang TEST_CFG. Weiters gehört zum Registerblock 32 das bereits angesprochene BACKUP-Register 14, in das das jeweils zu testende Datenwort gespeichert wird (s. Eingang TDATAIN). Ferner wird im Registerblock 32 der Vergleich der jeweiligen Testadresse - die ebenfalls im Registerblock 32 erzeugt wird - mit etwaigen Zugriffsadressen durchgeführt.

Der Testkontrollblock 33, dessen Funktion nachfolgend anhand der Zustandsdiagramme gemäß Fig.11 bis 15 näher erläutert werden wird, steuert den gesamten Testablauf, wogegen der Lesemultiplexer 34 bei Lesezugriffen durch den Prozessor 12 die entsprechenden Daten - am Ausgang TC_DATA - weiterleitet. Im Einzelnen handelt es sich dabei um folgende Daten:

- Statusdaten bei Lesezugriffen auf das Status-Register (s. STATUS_REG in Fig.6);
- Daten aus dem Register 20 bzw. 21 - DATA_REG1 bzw. DATA_REG2 - bei Lesezugriffen auf ein unmittelbar zuvor zum Einschreiben zugeführtes Datenwort, wobei sich der Schreibzugriff noch in der Pipeline 19 der Testeinrichtung 10 befindet;
- Daten CORR_DATA bei Lesezugriffen auf Adressen, die korrigierbare Fehler beinhalten, wenn eine solche Korrektur erwünscht ist, wofür CORRECT_EN=1 eingestellt wird, wobei die Daten gegebenenfalls invertiert ausgegeben werden (abhängig vom Steuersignal INV_READ, d.h. abhängig vom Ergebnis des Vergleichs der Zugriffs-Adresse mit der Testadresse;
- Daten BACKUP_REG bei Lesezugriffen auf die aktuelle Testadresse (HIT=1), wobei die Daten gegebenenfalls invertiert ausgegeben werden (wiederum abhängig vom Steuersignal INV_READ).

Der Testkontrollblock 33 beherbergt alle Zustandsmaschinen der Testeinrichtung 10 und steuert - unter Einbeziehung der Testkonfiguration TEST_CFG, des aktuellen Teststatuses TEST_STATUS und etwaiger aufgetretener Fehler MEM_ERROR und MARCH_ERROR - den Testverlauf über TEST_CTRL und die Test-Speicherzugriffe über TCTRL. Außerdem gibt der Testkontrollblock 33 Statusinformationen bezüglich der gefundenen Fehler bzw. bezüglich des Teststatuses an den Prozessor 12 weiter (s. Signal STATUS).

Der im Einzelnen in Fig.7 näher veranschaulichte Registerblock 32 enthält ein Konfigurationsregister 35, welches Test-Konfigurationsdaten TEST_CFG und CORRECT_EN speichert und über ADDR_REG1 und DAT_REG1 beschrieben wird. In der vorliegenden Implementierung werden sowohl das Konfigurationsregister 35 als auch ein Statusregister 36 über die normalen Speicheradressen via ADDR_REG1 angesprochen ("memory mapped"). Dies ist aber nicht zwingend notwendig. Es wäre auch möglich, auf diese Register 35, 36 über eigene Leitungen (Signale) zuzugreifen.

Das Statusregister 36 speichert Informationen über z.B. die Adresse, bei deren Test ein Fehler gefunden wurde (MADDR), die Bitposition des Fehlers im Speicherwort (TBIT_CNT), in welchem Testlauf (TEST_CTRL) und in welchem Testzyklus (TC_CNT) der Fehler gefunden wurde, um welchen Fehler es sich handelt (MEM_ERROR und MARCH_ERROR), welche Testkonfiguration verwendet wurde (TEST_CRG), u.s.w.. Der Inhalt des Statusregisters 36, STATUS_REG, wird an den Lesemultiplexer 34 der Testeinheit 18 weitergegeben.

Der Registerblock 32 enthält weiters ein Korrekturregister 37, das bei Auffinden eines Fehlers das korrigierte Datenwort (CORR_DATA) und die dazugehörige Adresse (CORR_ADDR) speichert. Diese Daten werden dann für eine etwaige sog. Soft-Fehler-Korrektur verwendet, d.h. über zwei Multiplexer 38, 39 den Signalen TADDR und TDATAOUT zugewiesen und für den Korrekturschreibzugriff verwendet. Eine erfolgreiche Fehlerkorrektur wird durch Zurücklesen der Korrekturdaten via TDATAIN und deren Vergleich mit CORR_DATA in einem Komparator 40 bestätigt. Sollten die Daten dann nicht übereinstimmen, so war die Korrektur erfolglos, und es handelt sich um einen nicht korrigierbaren Speicherfehler (sog. Hard-Fehler).

Das Backup-Register 14 übernimmt zu Beginn des Tests auf Wort-Ebene die ursprünglichen Daten TDATAIN des zu testenden Speicherwortes und speichert sie bis zum Ende des Wort-Tests. Etwaige Lesezugriffe des Prozessors 12 auf die aktuelle Testadresse werden auf dieses Backup-Register 14 umgeleitet; d.h. der Prozessor 12 erhält die Daten aus dem Backup-Register 14. Der Inhalt des Backup-Registers 14 - BACKUP_REG - wird dem Lesemultiplexer 34 der Testeinheit 18, der die Daten gegebenenfalls an den Prozessor 12 weiterleitet, und einem Testdaten-Generator und Komparator-Block 42, der daraus die aktuellen Testdaten erzeugt, zugeführt.

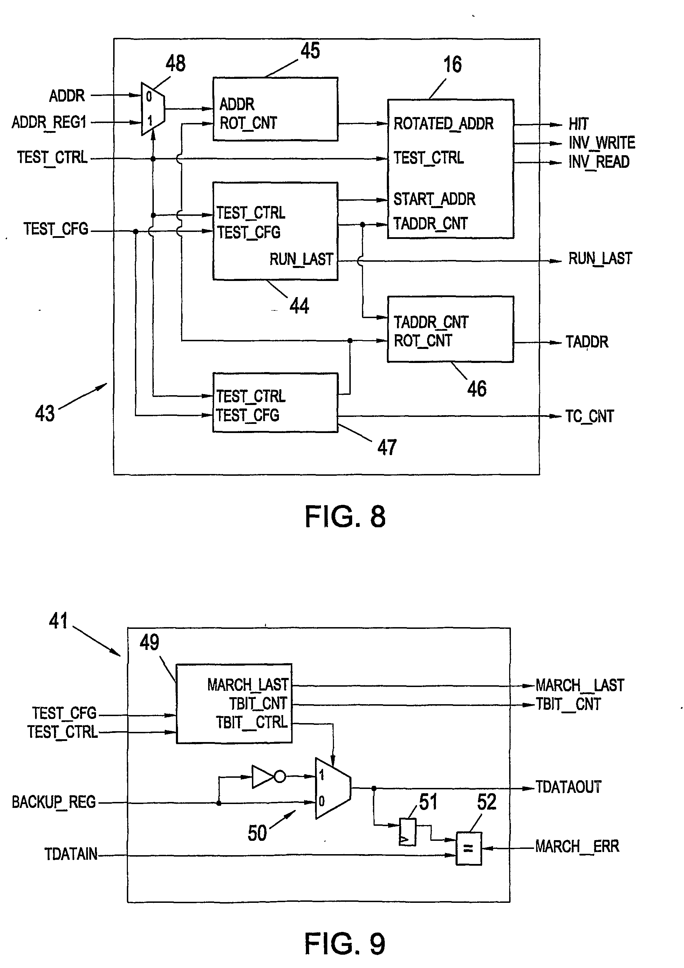

Schließlich enthält der Registerblock 32 noch einen Testadressen-Generator- und Adressenkomparator-Block 43, der nachfolgend anhand der Fig.8 näher erläutert wird.

Der Testadressen-Generator- und Adressenkomparator-Block 43 - s. Fig.8 - erzeugt eine bestimmte Adressenreihenfolge und vergleicht bei Schreib- und Lesezugriffen des Prozessors 12 die aktuelle Testadresse mit der Zugriffsadresse des Prozessors 12, um gegebenenfalls die Daten zu invertieren.

Das Vergleichsresultat des eigentlichen Adressenkomparators 16 wird über die Signale INV_WRITE (Invertierung der Schreibdaten), INV_READ (Invertierung der Lesedaten) und HIT (Gleichheit der Zugriffsadresse und der aktuellen Testadresse, wobei Schreibzugriffe den Wort-Test zurücksetzen, so dass dieser von Neuem beginnt, und Lesezugriffe auf das Backup-Register 14 umgeleitet werden) angezeigt. Der Vergleich wird mit Hilfe einer Startadresse START_ADDR, die von einem Testadressenzähler 44 zugeführt wird, ferner mit Hilfe eines den aktuellen Stand des Testadressenzählers 44 angebenden Signals TADDR_CNT und mit Hilfe der gegebenenfalls nach rechts (s. Rechts-Rotiereinheit 45 in Fig.8) rotierten Prozessor-Zugriffsadresse durchgeführt, wobei das Vergleichsergebnis noch vom momentanen Testverläuf TEST_CTRL abhängig ist.

Der Testadressenzähler 44 erzeugt entsprechend der gewählten Testkonfiguration TEST_CFG und dem aktuellen Testverlauf TEST_CTRL eine inkrementell aufsteigende oder dekrementell absteigende Adressenreihenfolge TADDR_CNT mit konstanter oder variabler Startadresse je Testzyklus. Er zeigt außerdem das Erreichen der letzten zu testenden Adresse, also das Ende eines Testlaufes (ein Testzyklus besteht wie erwähnt aus vier Testläufen), über ein Signal RUN_LAST an.

Diese absteigende bzw. aufsteigende Adressenreihenfolge wird, falls die Erkennung sog. SOADF-Fehler (SOADF - Stuck open adress decoder fault; ein Fehler, bei dem durch eine Unterbrechung in der Dekodierlogik des Adressendekoders ein sequentielles Verhalten auftritt, was zur Folge hat, dass für ein bestimmtes Adressenpaar beide Zugriffe auf die erste Adresse erfolgen) nicht unterstützt wird, direkt als Testadressen-Reihenfolge verwendet, d.h. TADDR=TADDR_CNT.

Für den Fall, dass die Erkennung von SOADF-Fehlern unterstützt werden soll, sind die Rechts-Rotiereinheit 45 sowie eine Links-Rotiereinheit 46 vorgesehen. Die Links-Rotiereinheit 46 erzeugt dann aus der inkrementell aufsteigenden bzw. aus der dekrementell absteigenden Adressenreihenfolge eine um ein Zählsignal ROT_CNT nach links rotierte Testadressen-Reihenfolge. Die Rechts-Rotiereinheit 45 ist dazu ausgebildet, die Prozessor-Zugriffsadresse um die entsprechende Anzahl von Bits nach rechts zu rotieren. Erst dadurch wird der Vergleich mit der aktuellen Testadresse möglich. Das Zählsignal ROT_CNT wird dabei in einem Testzykluszähler 47 erzeugt, der die Anzahl der bereits durchgeführten Testzyklen zählt. Der Zählerstand wird über das Signal TC_CNT weitergegeben. Für den Fall, dass die Erkennung von SOADF-Fehlern unterstützt wird, liefert das Signal ROT_CNT den Stand des Testzyklenzählers 47 an die Rotiereinheiten 45, 46. Dieses Signal ROT_CNT gibt die Anzahl der Bits an, um die die Adressen in den Rotiereinheiten 45, 46 rotiert werden. (Selbstverständlich können die beiden Rotiereinheiten 45, 46 auch in genau vertauschter Zuordnung verwendet werden, d.h. die Rechts-Rotiereinheit 45 erzeugt die rotierte Testadressen-Reihenfolge und die Links-Rotiereinheit 46 ermöglicht den Adressenvergleich.)

Das Signal TADDR_CNT des Testadressenzählers 44 gibt immer die aktuelle Testadresse im originalen Adressraum wieder. TADDR ist die aktuelle Testadresse im rotierten Adressraum. Die Prozessor-Zugriffsadresse liegt im rotierten Adressraum. Um sie mit der aktuellen Testadresse im originalen Adressraum vergleichen zu können, muss sie zurückrotiert werden. Danach kann die Prozessor-Zugriffsadresse im Adressenkomparator 16 mit der aktuellen Testadresse im originalen Adressraum verglichen werden; ROTATED_ADDR=TADDR_CNT.

Die Wahl der Prozessor-Zugriffsadresse (s. Steuersignal TEST_CTRL) erfolgt über einen Multiplexer 48 in der Weise, dass für einen Lesezugriff die Adresse ADDR gilt und für einen Schreibzugriff die Adresse ADDR_REG1.

Der in Fig.9 näher veranschaulichte Testdaten-Generator- und -Komparator-Block 41 erzeugt aus dem Inhalt (BACKUP_REG) des Backup-Registers 14 des Registerblocks 32 die entsprechenden Testdaten für den Test eines Speicherworts auf Wort-Ebene und vergleicht die geschriebenen Testdaten mit den gelesenen Daten.

Der Testbit-Kontroller 49 steuert - entsprechend dem Testverlauf TEST_CTRL und in Abhängigkeit von der gewählten Testkonfiguration TEST_CFG - die Generierung der Testdaten TDATAOUT und zeigt die Anzahl der bereits getesteten Bits mit dem Signal TBIT_CNT und das Ende eines Wort-Tests mit dem Signal MARCH_LAST an.

Das Signal BACKUP_REG stellt den Inhalt des Backup-Registers 14 zur Verfügung. Das Backup-Register 14 übernimmt zu Beginn des Tests auf Wort-Ebene (March-Tests) den ursprünglichen Inhalt des zu testenden Speicherworts. Durch Invertierung einer variablen Anzahl von Bits entsteht das aktuelle Testdatum, das über das Signal TDATAOUT in den Speicher 11 geschrieben wird. Welche Bits nun invertiert werden, steuert das Signal TBIT_CTRL des Testbit-Kontrollers 49. Wenn z.B. TBIT_CTRL gleich "00111" ist, so werden die Bits 0 (rechter 1er), 1 (nächster 1er) und 2 (1er in der Mitte des Signals) über eine Inverter-Multiplexer-Schaltung 50 invertiert. Ein Datum "00001" im Backup-Register 14 erscheint somit als "00110" am Ausgang (TDATAOUT="00110"). Das Ausgangssignal TDATAOUT wird zusätzlich in einem Register 51 zwischengespeichert. Nach jedem Schreibzugriff folgt im Test auf Wort-Ebene ein Lesezugriff. Das gelesene Datum wird über den Eingang TDATAIN einem Komparator 52 zugeführt, der das gelesene Datum mit dem zuvor geschriebenen Datum vergleicht. Sollten die Daten TDATAIN und TDATAOUT nicht übereinstimmen, so ist ein Fehler aufgetreten; aus irgendeinem Grund konnte das Datenwort nicht korrekt in den Speicher 11 geschrieben werden. Lesedatum und Schreibdatum stimmen nicht überein. Das Signal MARCH_ERROR wird in diesem Fall auf 1 gesetzt.

Bevor nun beispielhaft der Ablauf beim Testen des Speichers 11 näher erläutert wird, sollen nachfolgend einige typische Fehler kurz zusammengefasst werden:

- SAF (stuck-at-faults)-Fehler: Eine Speicherzelle kann ihren logischen Wert nicht ändern;
- TF (transition fault)-Fehler: Eine Speicherzelle kann nicht ihren logischen Wert von "0" auf "1" oder aber von "1"

EP 1 425 665 B1

auf "0" ändern;

- SOADF-Fehler: Ist ein SOF (stuck open fault)-Fehler im Adress-Dekoder;
- CF (coupling fault)-Fehler: Dieser Fehler (Kopplungsfehler) liegt vor, wenn ein bestimmter Übergang oder Wert in einer Speicherzelle einen bestimmten Übergang oder Wert in einer anderen Speicherzelle (der "gekoppelten" Zelle) verursacht;
- BF (bridging fault)-Fehler: Ein BF-Fehler liegt vor, wenn eine galvanische Verbindung zwischen Zellen oder Leitungen des Speichers existiert;
- Adressdekoder-Fehler
  z.B. A: eine Adresse kann keiner Zelle zugeordnet werden (Adressierung erreicht Zelle nicht);
  B: es erfolgt mit einer Adresse die Adressierung mehrerer Zellen;
  C: es wird eine Zelle von mehreren Adressen erreicht;
  D: Kombination der Fehler B und C;
- Kombinierte Fehler:
  z.B. SAF-Fehler mit TF-Fehler oder CF-Fehler.

Wenngleich beim vorliegenden Speichertest als übergeordneter Fehlertest ein Paritätstest mit Hilfe eines Paritätsbits CB (bzw. EC) als Checkbit (Prüfbit) durchgeführt werden kann, wird doch bevorzugt ein Hamming-Code verwendet, so dass der vorliegende Speichertest dann in der Lage ist, Mehrfach-Fehler zu erkennen und gegebenenfalls zu korrigieren.

Wie bereits vorstehend dargelegt, ist es weiters mit dem vorliegenden Speichertest möglich, sog. Soft-Fehler selbsttätig im Speicher zu beseitigen, da auf Wort-Test-Ebene das jeweils ausgelesene und im Backup-Register 14 gespeicherte Wort wieder in den Speicher 11 zurückgeschrieben und neuerlich ausgelesen wird. Ferner ist es durch die Generierung variabler Startadressen (mit Hilfe einer Gray-Codierung) möglich, die Fehlererkennungsrate von miteinander verknüpften Kopplungsfehlern ("linked coupling faults") zu verbessern. Durch die Erzeugung verschiedener Adressenreihenfolgen können auch SOADF-Fehler (Stuck-open Adressdekoder-Fehler) erkannt werden.

Im Zuge der Testkonfiguration (im Konfigurationsregister 35) können drei alternative Implementierungen eines MARCH-Algorithmus vorgesehen werden. So kann ein SAF/TF MT (stuck-at fault/transition fault march test) zur schnellen Erkennung einfacher Fehler implementiert werden. Der SRAM ESTW MT (SRAM extended split transparant word march test) ist als abgeänderte Variante des March C- March-Algorithmus dazu vorgesehen, zusätzlich Kopplungsfehler - mit Ausnahme der durch Lesezugriffe verursachten sog. read-disturb-Kopplungsfehler - zu finden. Der ESTW MT (extended split transparent word march test) dient zur Erkennung auch dieser read-disturb-Kopplungsfehler.

Die vorerwähnten Rechts- bzw. Links-Rotiereinheiten 45 bzw. 46 dienen dazu, SOADF-Fehler detektieren zu können. Diese beiden Rotiereinheiten 45, 46 können demgemäß auch weggelassen werden, wenn eine Detektion von SOADF-Fehlern nicht benötigt wird. In diesem Fall kann der Ausgang des Multiplexers 48 gemäß Fig.8 als Eingang für den Adressenkomparator 16 verwendet werden; der Ausgang TADDR_CNT des Testadressen-Zählers 44 wird dann dem aktuellen Testadressen-Signal TADDR gleichgesetzt. Wenn jedoch die beiden Rotiereinheiten 45, 46 vorgesehen sind, so verschieben sie die jeweiligen Adressen nach rechts bzw. links. Im Einzelnen verschiebt die Rechts-Rotiereinheit 45 die Zugriffsadresse (Eingang ADDR), wie sie vom Prozessor 12 verlangt wird, um eine durch das Signal ROT_CNT vorgegebene Anzahl von Bits nach rechts. Die Links-Rotiereinheit 46 verschiebt den Wert des Testadressen-Zählers 44 (Signal TADDR_CNT) um die entsprechende Anzahl Bits (Signal ROT_CNT) nach links. Das Resultat ist die tatsächliche Testadresse TADDR. Das Signal ROT_CNT rührt von der Testzyklen-Zählung im Testzyklen-Zähler 47 her.

SOADF-Fehler werden beim Test durch eine Kombination von zwei aufeinanderfolgenden Adressen, die sich nur in einem Bit unterscheiden, aktiviert und detektiert. Wenn nur ein einzelnes Bit sich von einer Adresse auf die andere ändert, bewirkt ein SOADF-Fehler, dass auf ein Wort, auf das bereits zuvor zugegriffen wurde, neuerlich zugegriffen wird. Voraussetzung für die Erkennung derartiger SOADF-Fehler ist somit, dass bei aufeinanderfolgenden Adressen beim Test der Fehler aktiviert wird. Wenn nun aber eine normale Reihe von Adressen, beispielsweise mit einer Breite von drei Bits, angenommen wird, so liegen z.B. die Adressen Nr. 3 und 7 in dieser Adressenreihe - die annahmeweise, wenn sie hintereinander zugegriffen werden, einen SOADF-Fehler auslösen und erkennen lassen - zu weit auseinander, d.h. auf sie wird nicht in Folge unmittelbar aufeinander zugegriffen. Die Adressen Nr. 1 bis 8 können beispielsweise wie folgt angeschrieben werden:.

| Adressen Nr. | 1 | 2 | 3 | 4 | 5 | 6 | 7 | 8 |
|---|---|---|---|---|---|---|---|---|
| | 000 | 001 | 010 | 011 | 100 | 101 | 110 | 111 |

Wenn nun jedoch die vorstehenden Adress-Codes jeweils um ein Bit nach rechts rotiert werden, d.h. die Bits werden jeweils nach rechts verschoben, und das rechts herausfallende Bit wird links wieder angefügt, so ergibt sich folgende um ein Bit nach rechts "rotierte" Adressenreihe:

| Adressen Nr. | 1 | 2 | 3 | 4 | 5 | 6 | 7 | 8 |
|---|---|---|---|---|---|---|---|---|
| | 000 | 100 | 001 | 101 | 010 | 110 | 011 | 111 |

Wie ersichtlich, liegen die Bit-Folgen "010" (ursprüngliche Adressen Nr. 3) und "110" (ursprüngliche Adressen Nr. 7) nunmehr als fünfte und sechste Adresse unmittelbar hintereinander. Zu erwähnen ist hier, dass zufolge der Umkehrung der Adressenreihenfolge (absteigend statt aufsteigend) im zweiten Testlauf die Adresse "110" (jetzt nach dem Rotieren die sechste Adresse) tatsächlich als dritte Adresse vor der vierten Adresse "010" zugegriffen wird. Beim Zugriff auf die Adresse "010" würde der Inhalt der Zelle mit der Adresse "110" erhalten werden, was bei der Überprüfung mit Hilfe der Prüfbits zu einer Fehlermeldung führt. Wie somit ersichtlich, können durch dieses Verschieben oder Rotieren der Adressbits derartige SOADF-Fehler erkannt werden.

Ganz allgemein wird beim vorliegenden Speichertest der zu testende Speicher 11 wie erwähnt in vier Testläufen (1) bis (4) in absteigender und aufsteigender Adressenreihenfolge überstrichen, vgl. auch das analog zu Fig.2 ausgelegte Schema von Fig.10. Die Adressenreihenfolge ist dabei nicht unbedingt inkrementell (bzw. dekrementell) zu verstehen. Die absteigende Adressenreihenfolge sollte jedoch die exakte Umkehrung der aufsteigenden Adressenfolge darstellen. Die Speicherwörter des Speichers 11 werden bei diesem Test nacheinander auf Fehler untersucht, wobei ein Testzyklus wie folgt aussieht:

- Testlauf (1)

  (a) Ermitteln einer Startadresse (=aktuelle Speicheradresse)
  (b) Lesen und Testen der aktuellen Speicheradresse
  (c) Zwischenspeichern des gelesenen Wortes im Backup-Register 14
  (d) Testen der aktuellen Speicheradresse mittels March-Fragment I
  (e) Ermitteln der Folgeadresse in aufsteigender Adressenreihenfolge
  (f) Fortsetzen mit dem Testlauf (1), Schritt (b), solange noch ungetestete Adressen vorhanden sind.

- Testlauf (2)

  (a) Rücksetzen der aktuellen Speicheradresse auf die Start adresse von Testlauf (1) (s. dort Schritt (a))
  (b) Lesen und Testen der aktuellen Speicheradresse
  (c) Zwischenspeichern des gelesenen Wortes im Backup-Register 14
  (d) Testen der aktuellen Speicheradresse mittels March-Fragment II
  (e) Ermitteln der Folgeadresse in aufsteigender Adressenreihenfolge
  (f) Fortsetzen mit dem Testlauf (2), Schritt (b), solange noch ungetestete Adressen vorhanden sind.

- Testlauf (3)

  (a) Beibehalten der letzten aktuellen Speicheradresse aus dem Testlauf (2)
  (b) Lesen und Testen der aktuellen Speicheradresse
  (c) Zwischenspeichern des gelesenen Wortes im Backup-Register 14
  (d) Testen der aktuellen Speicheradresse mittels March-Fragment III
  (e) Ermitteln der Folgeadresse in absteigender Adressenreihenfolge
  (f) Fortsetzen mit dem Testlauf (3), Schritt (b), solange noch ungetestete Adressen vorhanden sind.

- Testlauf (4)

  (a) Rücksetzen der aktuellen Speicheradresse auf jene von Testlauf (3), Schritt (a)
  (b) Lesen und Testen der aktuellen Speicheradresse
  (c) Zwischenspeichern des gelesenen Wortes im Backup-Register 14
  (d) Testen der aktuellen Speicheradresse mittels March-Fragment IV
  (e) Ermitteln der Folgeadresse in absteigender Adressenreihenfolge
  (f) Fortsetzen mit dem Testlauf (4), Schritt (b), solange noch ungetestete Adressen vorhanden sind
  (g) Beginnen des nächsten Test-Zykluses mit Testlauf (1).

Für die March-Fragmente I bis IV gibt es beim vorliegenden Ausführungsbeispiel die drei erwähnten unterschiedlichen Tests auf Wort-Ebene:

- SAF/TF MT (Stuck-AT Fault/Transition Fault March Test)
- SRAM ESTW MT (SRAM Extended Split Transparent Word March Test)
- ESTW MT (Extended Split Transparent Word March Test).

(Selbstverständlich sind auch andere bzw. weitere Implementierungen möglich.)

Das Testen der aktuellen Speicheradresse (Schritt (d) in den Testläufen (1) bis (4) geht für Wort-Test SAF/TF MT wie folgt vor sich:

1. Invertieren aller Bits des in Schritt (b) gelesenen Wortes
2. Zurückschreiben des manipulierten Wortes in die aktuelle Speicheradresse
3. Lesen der aktuellen Speicheradresse
4. Kontrolle auf Übereinstimmung des manipulierten Wortes und des in Schritt 3. gelesenen Wortes.

Das Testen der aktuellen Speicheradresse in den Schritten (d) erfolgt für den Test SRAM ESTW MT wie folgt (die Schritte 1 bis 3 sind optional) :

1. Zurückschreiben des jeweils in Schritt (b) gelesenen Wortes in die aktuelle Speicheradresse
2. Lesen der aktuellen Speicheradresse
3. Kontrolle auf Übereinstimmung des in Schritt 2 gelesenen Wortes und des in den Testläufen in Schritt (b) gelesenen Wortes
4. Invertieren der einzelnen Bits des im jeweiligen Schritt (b) gelesenen Wortes in aufsteigender oder absteigender Bitpositionsreihenfolge
5. Zurückschreiben des manipulierten Wortes in die aktuelle Speicheradresse
6. Lesen der aktuellen Speicheradresse
7. Kontrolle auf Übereinstimmung des manipulierten Wortes und des in Schritt 6. gelesenen Wortes
8. Fortfahren mit Schritt 4., bis alle Bits des Wortes invertiert sind.

Das Testen der aktuellen Speicheradresse in den Schritten (d) der Testläufe (1) bis (4) geht für den Test ESTW MT so vor sich:

1. Zurückschreiben des im jeweiligen Schritt (b) gelesenen Wortes in die aktuelle Speicheradresse
2. Lesen der aktuellen Speicheradresse
3. Kontrolle auf Übereinstimmung des in Schritt 2. gelesenen Wortes und des in Schritt (b) gelesenen Wortes
4. Einmaliges Wiederholen der Schritte 2. und 3.
5. Invertieren der einzelnen Bits des im jeweiligen Schritt (b) gelesenen Wortes in aufsteigender oder absteigender Bitpositionsreihenfolge
6. Zurückschreiben des manipulierten Wortes in die aktuelle Speicheradresse
7. Lesen der aktuellen Speicheradresse
8. Kontrolle auf Übereinstimmung des manipulierten Wortes und des in Schritt 7. gelesenen Wortes
9. Einmaliges Wiederholen der Schritte 7. und 8.
10. Fortfahren mit Schritt 5., bis alle Bits des Wortes invertiert sind.

Die March-Fragmente I, II, III und IV des Tests SAF/TF MT sind identisch. Die March-Fragmente des Tests SRAM ESTW MT und ESTW MT unterscheiden sich in der Bitpositionsreihenfolge, in denen die einzelnen Bits invertiert werden.

Die Fehlererkennung ist bei den vorstehenden Testmethoden aufgrund der Verletzung der Parität (bei Verwendung eines Paritätsbits als Fehlercode) oder aufgrund der Verletzung des Hamming-Codes (bei möglicher Verwendung eines Hamming-Codes als Fehlercode) durch fehlerhafte Bits im gelesenen Wort möglich. Wesentlich für die Erkennung von Adressdekoder-Fehlern ist die Änderung der Interpretation des Fehlercodes nach jeder erfolgten Invertierung des Wortes in der aktuellen Speicheradresse nach dem jeweiligen Schritt (d) in den einzelnen Testläufen (1) bis (4).

Der Test SAF/TF MT ist für die rasche Erkennung von SAF-Fehlern, TF-Fehlern, Adressdekoder-Fehlern, SOADF-Fehlern und Soft-Fehlern ausgelegt. Der Test SRAM ESTW MT erkennt zusätzlich Bridging-Fehler (BF) und Kopplungsfehler (CF), jedoch keine "read disturb"-CF-Fehler. Die Erkennung dieser Fehler wird durch den Test ESTW MT gewährleistet.

Das Auffinden eines Fehlers wird unmittelbar der auf den Speicher zugreifenden Einheit (d.i. im vorliegenden Beispiel der Prozessor 12) gemeldet. In Abhängigkeit von der gewählten Konfiguration des Testvorganges wird sodann der Speichertest unterbrochen oder - wenn möglich - der Fehler korrigiert und der Speichertest fortgesetzt.

Die Erkennung der SOADF-(Stuck-Open-Adressdekoder)Fehler wird wie beschrieben durch die "rotierte" Adressenreihenfolge ermöglicht. Die rotierte Adressenreihenfolge ergibt sich, wenn die ursprüngliche Adressenreihenfolge um eine definierte Anzahl von Bits rotiert wird. Aus der ursprünglichen inkrementellen Adressenreihenfolge 000,001,010,011,100,101,110,111 entsteht daher nach Rotation um ein Bit nach rechts wie beschrieben die verschobene Adressenreihenfolge 000,100,001,101,010,110,011,111 und nach Rotation um zwei Bits nach rechts die Adressenreihenfolge 000,010,100,110,001,011,101,111.

Die Adressenreihenfolge wird mit jedem Testzyklus um ein Bit rotiert. Das einzelne Bit, durch das sich zwei aufeinanderfolgende Adressen in der ursprünglichen inkrementellen Adressenreihenfolge unterscheiden (z.B. 000 und 001), wird dadurch innerhalb von w Testzyklen (w = Adressbreite in Bits) über das gesamte Adresswort geschoben. Im vorliegenden Beispiel (mit w=3) geschieht das nach drei Testzyklen: 000,001 im 1. Zyklus, 000,100 im zweiten Zyklus und 000,010 im 3. Zyklus. Nach w Testzyklen ist dadurch der in Goor, A. J. van de, Testing of Semiconductor Memories, Theory and Practice, 1995, Seite 447-449, vorgeschlagene Test für SOAD-Fehler abgedeckt.

In Fig.11 ist die durch den Testkontrollblock 33 (s. Fig.6) gegebene Testlauf-Zustandsmaschine veranschaulicht. Diese Testlauf-Zustandsmaschine gemäß Fig.11 kontrolliert den Ablauf eines Testzykluses, der in die vier Testläufe (1) bis (4) unterteilt ist. Nach einem Rücksetzen des Systems ("Reset") befindet sich die Zustandsmaschine im Ruhezustand "Standby", indem sie so lange verharrt, bis der Prozessor 12 den Speichertest über einen Schreibzugriff auf das Konfigurations-Register 35 (s. Fig.7) startet. Nach dem Start durchläuft die Zustandsmaschine kontinuierlich die Zustände "Run1", "Run2", "Run3" und "Run4", entsprechend den vorbeschriebenen Testläufen (1) bis (4), um dann wieder mit dem Zustand "Run1" zu beginnen, falls der Prozessor kein Shutdown-Kommando (durch Beschreiben des Konfigurations-Registers 35) ausgegeben hat. In den Zuständen "Run3" und "Run4" wird eine absteigende Test-Adressenreihenfolge generiert. Nach Beendigung eines Testlaufs (1), (2), (3) oder (4) wird jeweils in den darauffolgenden Testlauf-Zustand gewechselt und der nächste Testlauf begonnen.

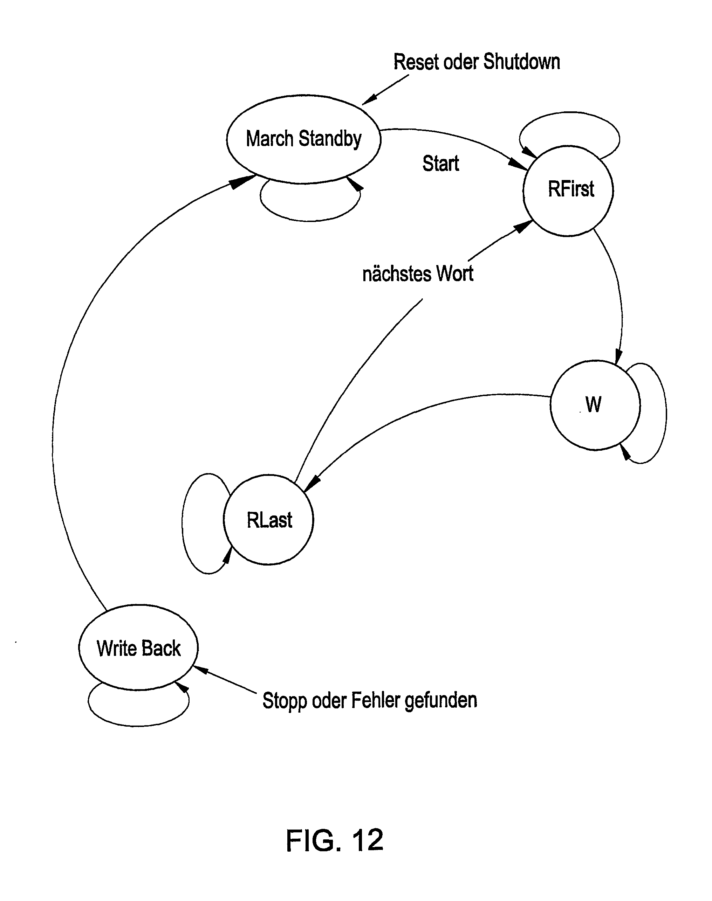

Die Wort-Test (March-Test)-Zustandsmaschinen sind in den Fig.12 bis 14 für die Wort-Tests (March-Tests) SAF/TF MT, SRAM ESTW MT und ESTW MT dargestellt.

Der Zustand "MarchStandby" in Fig.12 ist der Ruhezustand dieser Zustandsmaschinen. Dieser Zustand wird nach einem Reset, wenn der Prozessor 12 den Test anhält, oder wenn ein Fehler gefunden wurde, eingenommen. Der Prozessor 12 kann den Test entweder mit sofortiger Wirkung stoppen (Stopp), wobei dann vor Einnehmen des Ruhezustandes die ursprünglichen Daten des gerade getesteten Wortes im Zustand "WriteBack" aus dem Backup-Register 14 invertiert zurückgeschrieben werden und die aktuelle Testadresse geändert wird, oder mit einem Shutdown-Kommando nach Beendigung des aktuellen Testzykluses niederfahren. Bei Auffinden eines Fehlers reagiert die Zustandsmaschine wie nach einem Stopp durch den Prozessor 12 und kehrt über den Zustand "WriteBack" in den Ruhezustand zurück. Am Ende der Fehlerbehandlung muss der Prozessor die Test-Einrichtung 10 wieder starten (durch Beschreiben des Konfigurations-Registers 35). Diese Erläuterungen gelten für alle March-Test-Zustandsmaschinen.

Der SAF/TF March-Test (s. Fig.12) dient insbesondere dem Auffinden von SAF-Fehlern, TF-(Transitions) Fehlern und Adressdekoder-Fehlern. Er ist der schnellste und am einfachsten zu implementierende March-Test.

Nach einem Start durchläuft die Zustandsmaschine gemäß Fig.12 kontinuierlich den Zustandszyklus "RFirst"-"W"-"RLast", bis der Test durch einen Reset, durch ein Stopp-Kommando oder durch ein Shutdown-Kommando unterbrochen oder ein Fehler gefunden wird. Im Zustand "RFirst" wird der Inhalt des aktuellen Speicherworts im Backup-Register 14 abgelegt, der Inhalt mit Hilfe der Prüfbits auf Fehler untersucht und der March-Test begonnen. Alle Datenbits werden dann im Zustand "W" invertiert in den Speicher 11 zurückgeschrieben und im Zustand "RLast" wieder ausgelesen. Die Schreib- und Lesedaten werden verglichen. Sodann wird die Testadresse verändert und das nächste Speicherwort auf gleiche Weise getestet.

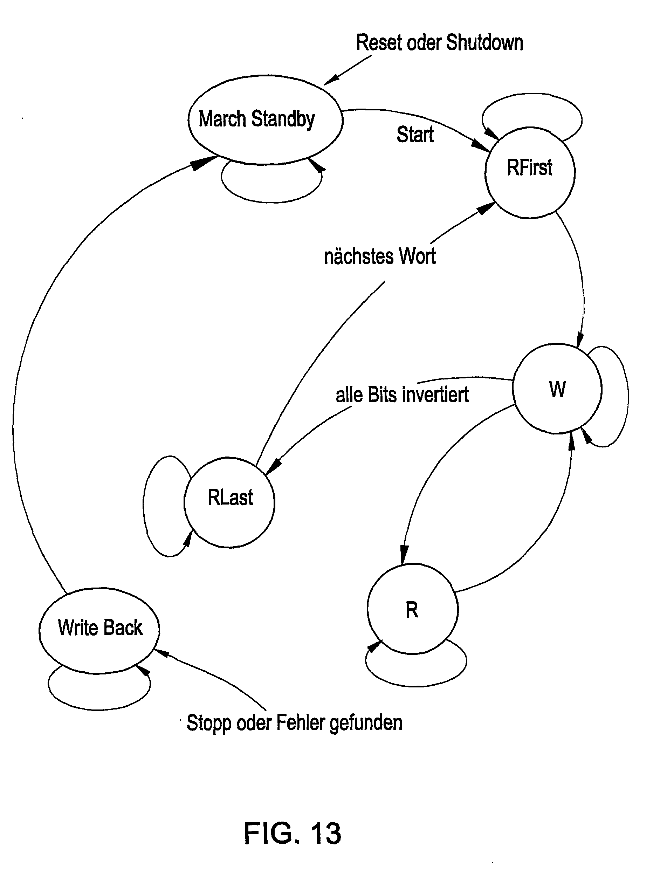

Die in Fig.13 gezeigte Zustandsmaschine für den SRAM ESTW March-Test unterscheidet sich von der des SAF/TF March-Tests (s. Fig.12) lediglich durch den zusätzlichen Zustand "R". Der SRAM ESTW March-Test findet die selben Fehler wie der SAF/TF March-Test und zusätzlich noch sogenannte Kopplungsfehler (CF): dabei verursacht eine Veränderung einer Speicherzelle bzw. ein Lesezu-griff auf eine Speicherzelle (read disturb CF-Fehler) eine ungewollte Beeinflussung einer weiteren Zelle.

Die Zustandsmaschine gemäß Fig.13 durchläuft den Testzyklus "RFirst"-"W"-"R"..."W"-"RLast", wobei die Abfolge "W"-"R" so oft wiederholt wird, bis alle Bits des Datenwortes invertiert worden sind. Im Zustand "W" wird also nicht ein vollkommen invertiertes Datenwort in den Speicher 11 zurückgeschrieben, sondern es wird mit jedem Schreibzugriff nur ein einziges Datenbit invertiert. Alternativ kann beim ersten Schreibzugriff, wenn also der Zustand "W" nach dem Zustand "RFirst" eingenommen wurde, das Datenwort auch unverändert zurückgeschrieben werden (dies dient dem Auffinden sogenannter write disturb CF-Fehler). Nach jedem Schreibzugriff werden die Daten im Zustand "R" zurückgelesen und mit den geschriebenen Daten verglichen. Nach dem letzten Schreibzugriff, bei dem alle Bits invertiert geschrieben werden, wechselt die Zustandsmaschine von Fig.13 in den Zustand "RLast". Das Datenwort wird ein letztes Mal zurückgelesen und auf Gleichheit zwischen geschriebenen und gelesenen Daten überprüft. Sodann wird die Testadresse geändert und das nächste Wort auf gleiche weise getestet.

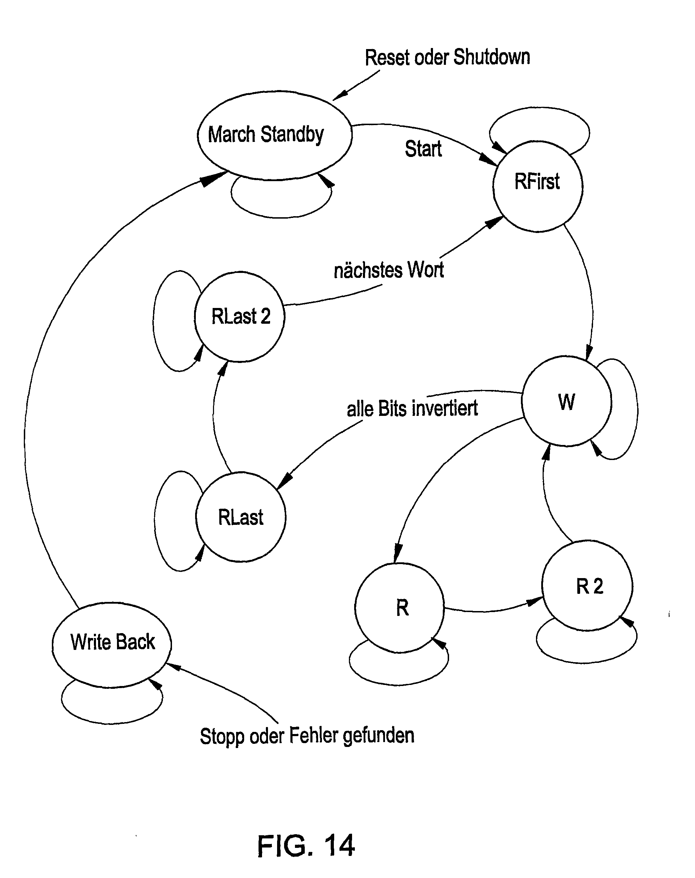

In Fig.14 ist die Zustandsmaschine für den ESTW March-Test gezeigt, der die selben Fehler wie der SRAM ESTW March-Test und zusätzlich auch die sog. read disturb CF-Fehler findet. Die Zustandsmaschine für den ESTW March-Test unterscheidet sich von der Zustandsmaschine für den SRAM ESTW MT (s. Fig.13) nur durch die Zustände "RLast2" und "R2". In diesen Zuständen wird das Datenwort nochmals ausgelesen und mit dem geschriebenen verglichen. Diese Vorgangsweise dient dem Auffinden der sog. read disturb CF-Fehler (das sind Kopplungsfehler, die durch einen Lesezugriff ausgelöst werden, d.h. der Lesezugriff auf eine Speicherzelle bewirkt eine Beeinflussung einer anderen Speicherzelle). Der Testzyklus ist also"RFirst"-"W"-"R"-"R2"...-"W"-"RLast"-"RLast2".

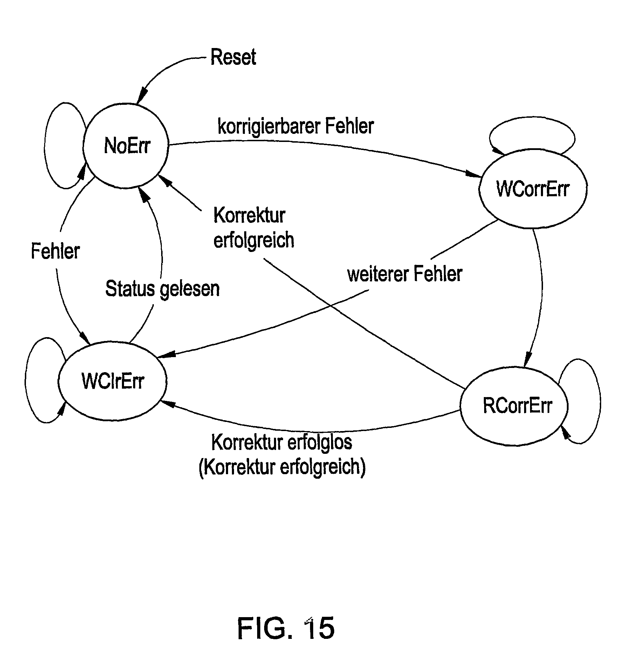

Die Fehlerbehandlungs-Zustandsmaschine ist in Fig.15 dargestellt. Bei Auffinden eines Fehlers wird, wenn der Fehler korrigierbar ist und die Soft-Speicherfehler-Korrektur aktiviert ist, vom Ruhezustand "NoErr" in den Zustand "WCorrErr" gewechselt und dort das korrigierte Datenwort in den Speicher 11 geschrieben. Daraufhin wird im Zustand "RCorrErr" die Korrektur zurückgelesen. Die Lesedaten werden mit den Schreibdaten verglichen. Bei Gleichheit (Korrektur war erfolgreich) wird wieder der Ruhezustand "NoErr" oder alternativ, falls der korrigierbare Fehler dem Prozessor 12 angezeigt werden soll, der Zustand "WC1rErr" eingenommen. Wenn die Korrektur erfolglos war, wird ebenfalls in den Zustand "WClrErr" gewechselt. Wird während des Schreibens der korrigierten Daten als Folge eines priorisierten Prozessor-Lesezugriffs ein weiterer Fehler gefunden, so wird die Fehlerkorrektur abgebrochen und in den Zustand "WC1rErr" gewechselt.

Tritt im Ruhezustand "NoErr" ein nicht-korrigierbarer Fehler auf, oder tritt ein korrigierbarer Fehler auf, aber die Soft-Speicherfehler-Korrektur ist nicht aktiviert, so wird ebenfalls der Zustand "WC1rErr" eingenommen. Beim Wechsel in diesen Zustand wird ein Flag (das sog. GO-Flag) im Konfigurations-Register 35 zurückgesetzt. Dies bewirkt ein Stoppen der March-Test Zustandsmaschine. Außerdem werden Statusinformationen im Statusregister 36 abgelegt (z.B. Fehleradresse, Fehlerbitposition im Speicherwort, Testlauf, Testzyklus, Fehlerart, etc.). Im Zustand "WC1rErr" wartet die Zustandsmaschine, bis der Prozessor 12 im Zuge der Fehlerbehandlung das niedrigste Wort des Statusregisters 36 ausliest, wodurch die Zustandsmaschine in den Ruhezustand zurückkehrt (das Signal CLR_ERROR wird gesetzt). Am Ende der Fehlerbehandlung durch den Prozessor 12 muss dieser die Test-Einrichtung 10 durch Schreiben des Konfigurations-Registers 35, insbesondere durch Setzen des GO-Flags, wieder starten. Die Test-Einrichtung 10 setzt sodann den zuvor unterbrochenen Test mit der nächsten Speicheradresse fort, um die selbe Fehlermeldung nicht nochmals zu bekommen bzw. um über die fehlerhafte Adresse hinweg zu kommen. Alternativ wäre auch ein kleiner Fehleradressen-Speicher denkbar, z.B. im Bereich des Status-Registers, vgl. auch Fig.7, Position 52, in welchem die Adressen der gefundenen fehlerhaften Speicherwörter abgelegt werden. Diese Fehleradressen könnten dann in den folgenden Testläufen einfach übersprungen werden, so dass ein und dieselbe Fehlermeldung nicht bei jedem Testlauf oder Testzyklus wiederholt wird und der Prozessor 12 nicht immer wieder die selbe Fehlerbehandlungsroutine ausführen muss.

## Patentansprüche

1. Verfahren zum Testen eines Speichers (11), wobei in Speicherzellen (13) des Speichers gespeicherte Datenwörter (D) mit zugeordneten Prüfbits (EC) zyklisch aus dem Speicher (11) ausgelesen und auf Fehler untersucht werden, **dadurch gekennzeichnet, dass** bei Speicherzugriffen während des Testens die jeweilige Zugriffs-Adresse mit der Adresse des gerade getesteten Datenworts verglichen wird, und dass bei einem Schreibzugriff das einzuschreibende Datenwort mit der zugehörigen Adresse zwischengespeichert und für einen etwaigen Lesezugriff verfügbar gehalten wird, während diese zugehörige Adresse mit der Adresse des gerade getesteten Datenworts verglichen wird.

2. Verfahren nach Anspruch 1, **dadurch gekennzeichnet, dass** das einzuschreibende Datenwort mit der zugehörigen Adresse und den zugehörigen Steuersignalen bis zum tatsächlichen Einschreiben in den Speicher (11) verfügbar gehalten wird.

3. Verfahren nach Anspruch 1 oder 2, **dadurch gekennzeichnet, dass** dem einzuschreibenden Datenwort bei seiner Zwischenspeicherung zumindest ein Prüfbit (EC) zugeordnet wird.

4. Verfahren nach Anspruch 3, **dadurch gekennzeichnet, dass** dem einzuschreibenden Datenwort mindestens ein Paritäts-Prüfbit zugeordnet wird.

5. Verfahren nach Anspruch 3, **dadurch gekennzeichnet, dass** dem einzuschreibenden Datenwort Hamming-Code-Prüfbits zugeordnet werden.

**6.** Verfahren nach Anspruch 3, **dadurch gekennzeichnet, dass** dem einzuschreibenden Datenwort Hsiao-Code-Prüfbits zugeordnet werden.

**7.** Verfahren nach einem der Ansprüche 1 bis 6, **dadurch gekennzeichnet, dass** alle im Speicher (11) enthaltenen Speicherzellen (13) bzw. gespeicherten Datenwörter (D) samt Prüfbits (EC) der Reihe nach in zumindest zwei Testläufen nacheinander, z.B. gemäß einem March-Test, getestet und jeweils in invertierter Form in den Speicher (11) zurückgeschrieben werden.

**8.** Verfahren nach Anspruch 7 mit einem der Ansprüche 3 bis 6, **dadurch gekennzeichnet, dass** jedes Datenwort (D) zuerst mit Hilfe seines Prüfbits (EC) oder seiner Prüfbits auf Fehler geprüft wird und danach ein Test auf Wort-Ebene auf dieses Datenwort angewendet wird.

**9.** Verfahren nach Anspruch 8, **dadurch gekennzeichnet, dass** das Datenwort (D) nach Überprüfung mit Hilfe des/der Prüfbits (EC) vollständig invertiert in den Speicher (11) zurückgeschrieben und danach wieder ausgelesen und durch Vergleich mit dem zuvor geschriebenen, vollständig invertierten Datenwort ($\bar{D}$) auf Fehler untersucht wird.

**10.** Verfahren nach Anspruch 8 oder 9, **dadurch gekennzeichnet, dass** das Datenwort (D) nach Überprüfung mit Hilfe des/der Prüfbits (EC) mehrmals teilweise invertiert in den Speicher (11) zurückgeschrieben und danach wieder ausgelesen und durch Vergleich mit dem zuvor geschriebenen, teilweise invertierten Datenwort auf Fehler untersucht wird, wobei das Datenwort ($\bar{D}$) zuletzt ebenfalls vollständig invertiert in den Speicher (11) geschrieben, nochmals zurückgelesen und mit dem zuletzt geschriebenen, vollständig invertierten Datenwort verglichen wird.

**11.** Verfahren nach Anspruch 8 oder 9, **dadurch gekennzeichnet, dass** das Datenwort (D) nach Überprüfung mit Hilfe des/der Prüfbits mehrmals teilweise invertiert in den Speicher (11) zurückgeschrieben und danach zweimal hintereinander ausgelesen und durch Vergleich mit dem zuvor geschriebenen, teilweise invertierten Datenwort auf Fehler untersucht wird, wobei das Datenwort ($\bar{D}$) zuletzt ebenfalls vollständig invertiert in den Speicher (11) geschrieben, nochmals zweimal zurückgelesen und jeweils mit dem zuletzt geschriebenen, vollständig invertierten Datenwort verglichen wird.

**12.** Verfahren nach einem der Ansprüche 7 bis 11 mit Anspruch 4, **dadurch gekennzeichnet, dass** nach erfolgtem Test auf Wort-Ebene jeweils die Interpretation des Paritäts-Prüfbits geändert wird, wobei von ungerader Parität auf gerade Parität und umgekehrt gewechselt wird.

**13.** Verfahren nach einem der Ansprüche 7 bis 11 mit Anspruch 5, **dadurch gekennzeichnet, dass** nach erfolgtem Test auf Wort-Ebene jeweils die Interpretation der Hamming-Code-Prüfbits geändert wird, wobei für eine gerade Anzahl von Bits, über die ein Hamming-Code-Prüfbit berechnet wird, von ungerader auf gerade Parität und umgekehrt gewechselt wird, wogegen für eine ungerade Anzahl von Bits, über die ein Hamming-Code-Prüfbit berechnet wird, die Interpretation unverändert bleibt.

**14.** Verfahren nach einem der Ansprüche 7 bis 13, **dadurch gekennzeichnet, dass** von insgesamt vier Testläufen pro Testzyklus zwei aufeinanderfolgende Testläufe gemäß einer aufsteigenden Adressenreihenfolge und die zwei anderen aufeinanderfolgenden Testläufe gemäß einer absteigenden Adressenreihenfolge durchgeführt werden.

**15.** Verfahren nach einem der Ansprüche 7 bis 14, **dadurch gekennzeichnet, dass** die einzuschreibenden, gegebenenfalls zwischengespeicherten Datenwörter samt Prüfbits jeweils in invertierter Form in den Speicher (11) eingeschrieben werden, wenn die Zugriffs-Adresse einer Speicherzelle (13) entspricht, deren Inhalt zu diesem Zeitpunkt in invertierter Form vorliegt.

**16.** Verfahren nach einem der Ansprüche 1 bis 15, **dadurch gekennzeichnet, dass** nach jedem Testzyklus die Startadresse für den nächsten Testzyklus geändert wird.

**17.** Verfahren nach Anspruch 16, **dadurch gekennzeichnet, dass** aus einer inkrementellen Startadressen-Reihenfolge eine Gray-codierte, gegebenenfalls von rechts nach links zu lesende Startadressen-Reihenfolge erzeugt wird.

**18.** Verfahren nach einem der Ansprüche 14 bis 17, **dadurch gekennzeichnet, dass** nach jedem Testzyklus die aufsteigende und absteigende Adressenreihenfolge um ein Bit rotiert wird.

**19.** Einrichtung zum Testen eines mit einer Zugriffseinheit (12) verbundenen Speichers (11), mit einer dem Speicher (11) zugeordneten Testeinheit (18) zum zyklischen Auslesen und Testen von Speicherzellen (13) des Speichers (11) bzw. von im Speicher gespeicherten Datenwörtern, **dadurch gekennzeichnet, dass** die Testeinheit (18) einen Adressen-Komparator (16) zum Vergleichen der Adresse des gerade getesteten Datenworts mit einer Zugriffs-Adresse im Falle eines gleichzeitig mit dem Test erfolgenden Speicherzugriffs durch die Zugriffseinheit (12) aufweist, und dass mit der Testeinheit (18) ein Zwischenspeicher (19) zur Zwischenspeicherung von einzuschreibenden Daten und zugehörigen Adressen sowie vorzugsweise Steuersignalen während des Adressenvergleichs verbunden ist.

**20.** Einrichtung nach Anspruch 19, **dadurch gekennzeichnet, dass** der Zwischenspeicher (19) zweistufig ausgeführt ist, um das jeweilige einzuschreibende Datenwort samt Adresse und Steuersignalen vor oder während des Einschreibens in den Speicher (11) für einen etwaigen Lesezugriff auf die Schreibadresse verfügbar zu halten.

**21.** Einrichtung nach Anspruch 20, **dadurch gekennzeichnet, dass** der etwaige Lesezugriff auf das einzuschreibende Datenwort über die mit beiden Zwischenspeicher-Stufen (20, 21) verbundene Testeinheit (18) erfolgt.

**22.** Einrichtung nach Anspruch 20 oder 21, **dadurch gekennzeichnet, dass** die beiden Zwischenspeicher-Stufen (20, 21) je durch ein Register gebildet sind.

**23.** Einrichtung nach einem der Ansprüche 19 bis 22, **dadurch gekennzeichnet, dass** dem Zwischenspeicher (19) ein Prüfbitgenerator (22) zum Hinzufügen von jeweils mindestens einem Prüfbit (EC) zum einzuschreibenden Datenwort zugeordnet ist.

**24.** Einrichtung nach Anspruch 23, mit einem der Ansprüche 17 bis 19, **dadurch gekennzeichnet, dass** der Prüfbitgenerator (19) im Datenpfad zwischen den beiden Zwischenspeicher-Stufen (20, 21) angeordnet ist.

**25.** Einrichtung nach Anspruch 23 oder 24, **dadurch gekennzeichnet, dass** der Prüfbitgenerator (22) zur Zuordnung von Paritäts-Prüfbits zum jeweiligen Datenwort ausgebildet ist.

**26.** Einrichtung nach Anspruch 23 oder 24, **dadurch gekennzeichnet, dass** der Prüfbitgenerator (22) zur Zuordnung von Hamming-Code-Prüfbits zum jeweiligen Datenwort ausgebildet ist.

**27.** Einrichtung nach Anspruch 23 oder 24, **dadurch gekennzeichnet, dass** der Prüfbitgenerator (22) zur Zuordnung von Hsiao-Code-Prüfbits zum jeweiligen Datenwort ausgebildet ist.

**28.** Einrichtung nach einem der Ansprüche 19 bis 27, **dadurch gekennzeichnet, dass** die Testeinheit (18) einen Testkontrollblock (33) mit einer Testlauf-Zustandsmaschine für mehrere Testläufe pro Testzyklus, einer Fehlertest-Zustands-Maschine und einer Fehlerbehandlungs-Zustandsmaschine enthält.

**29.** Einrichtung nach Anspruch 28, **dadurch gekennzeichnet, dass** alle Speicherzellen (13) des Speichers (11) in den verschiedenen Testläufen in einer vorgegebenen Reihenfolge ausgelesen und ihre Inhalte, d.h. Datenwörter (D) und Prüfbits (EC), jeweils getestet sowie in invertierter Form wieder zurückgeschrieben werden.

**30.** Einrichtung nach Anspruch 28, **dadurch gekennzeichnet, dass** jedes Datenwort (D) zuerst mit Hilfe seines/seiner Prüfbits (EC) auf Fehler geprüft wird und danach ein Test auf Wort-Ebene auf dieses Datenwort (D) angewendet wird, wobei das Datenwort (D) nach Beendigung des Tests auf Wort-Ebene im Speicher (11) invertiert vorliegt.

**31.** Einrichtung nach Anspruch 30, **dadurch gekennzeichnet, dass** das Datenwort (D) nach Überprüfung mit Hilfe des/der Prüfbits (EC) vollständig invertiert in den Speicher (11) zurückgeschrieben und danach wieder ausgelesen und durch Vergleich mit dem zuvor geschriebenen, vollständig invertierten Datenwort ($\overline{D}$) auf Fehler untersucht wird.

**32.** Einrichtung nach Anspruch 30 oder 31, **dadurch gekennzeichnet, dass** das Datenwort (D) nach Überprüfung mit Hilfe des/der Prüfbits (EC) mehrmals teilweise invertiert in den Speicher (11) zurückgeschrieben und danach wieder ausgelesen und durch Vergleich mit dem zuvor geschriebenen, teilweise invertierten Datenwort auf Fehler untersucht wird, wobei das Datenwort ($\overline{D}$) zuletzt ebenfalls vollständig invertiert in den Speicher (11) geschrieben, nochmals zurückgelesen und mit dem zuletzt geschriebenen, vollständig invertierten Datenwort verglichen wird.

**33.** Einrichtung nach Anspruch 30 oder 31, **dadurch gekennzeichnet, dass** das Datenwort (D) nach Überprüfung mit Hilfe des/der Prüfbits (EC) mehrmals teilweise invertiert in den Speicher (11) zurückgeschrieben und danach zweimal hintereinander ausgelesen und durch Vergleich mit dem zuvor geschriebenen, teilweise invertierten Datenwort auf Fehler untersucht wird, wobei das Datenwort ($\bar{D}$) zuletzt ebenfalls vollständig invertiert in den Speicher (11) geschrieben, nochmals zweimal zurückgelesen und jeweils mit dem zuletzt geschriebenen, vollständig invertierten Datenwort verglichen wird.

**34.** Einrichtung nach einem der Ansprüche 28 bis 33, **dadurch gekennzeichnet, dass** im Falle eines Paritäts-Prüfbits nach erfolgtem Test auf Wort-Ebene jeweils die Interpretation des Paritäts-Prüfbits geändert wird, wobei von ungerader Parität auf gerade Parität und umgekehrt gewechselt wird.

**35.** Einrichtung nach einem der Ansprüche 28 bis 33, **dadurch gekennzeichnet, dass** im Falle von Hamming-Code-Prüfbits nach erfolgtem Test auf Wort-Ebene jeweils die Interpretation der Hamming-Code-Prüfbits geändert wird, wobei für eine gerade Anzahl von Bits, über die ein Hamming-Code-Prüfbit berechnet wird, von ungerader auf gerade Parität und umgekehrt gewechselt wird, wogegen für eine ungerade Anzahl von Bits, über die ein Hamming-Code-Prüfbit berechnet wird, die Interpretation unverändert bleibt.

**36.** Einrichtung nach einem der Ansprüche 28 bis 35, **dadurch gekennzeichnet, dass** die Testlauf-Zustandsmaschine zwei aufeinanderfolgende Testläufe in einer aufsteigenden Adressenreihenfolge und zwei aufeinanderfolgende Testläufe in einer absteigenden Adressenreihenfolge vorsieht.

**37.** Einrichtung nach einem der Ansprüche 29 bis 36, **dadurch gekennzeichnet, dass** dem Zwischenspeicher (19) ein Inverter (31) und ein auch mit dem Inverter (31) verbundener Multiplexer (30) nachgeschaltet sind, um das jeweilige einzuschreibende Datenwort samt Prüfbit(s) dann, wenn seine Adresse einer Speicherzelle entspricht, deren Inhalt zu diesem Zeitpunkt in invertierter Form vorliegt, in invertiertem Zustand einzuschreiben.

**38.** Einrichtung nach einem der Ansprüche 19 bis 37, **dadurch gekennzeichnet, dass** die Testeinheit (18) einen dem Adressenkomparator (16) vorgeschalteten Testadressengenerator (43) mit Startadressen-Erzeugungsstufen- und Testadressenzähler-Einheit (44) aufweist.

**39.** Einrichtung nach Anspruch 38, **dadurch gekennzeichnet, dass** die Startadressen-Erzeugungsstufen-Einheit (44) aus einer inkrementellen Startadressen-Reihenfolge eine Gray-codierte, gegebenenfalls von rechts nach links zu lesende Startadressen-Reihenfolge erzeugt.

**40.** Einrichtung nach einem der Ansprüche 19 bis 39, **dadurch gekennzeichnet, dass** die Testeinheit (18) Rotier-Einheiten (45, 46) enthält, die nach jedem Testzyklus die aufsteigende und die absteigende Adressenreihenfolge um ein Bit rotieren und bei rotierter Testadressen-Reihenfolge einen Vergleich der Adresse des gerade getesteten Datenwortes mit einer Zugriffsadresse bei einem etwaigen Speicherzugriff durch die Zugriffseinheit (12) ermöglichen.

**41.** Einrichtung nach einem der Ansprüche 19 bis 40, **dadurch gekennzeichnet, dass** die Testeinheit (18) eine Fehlerkorrektureinheit (27) zur Korrektur von Fehlern in den getesteten Datenwörtern entsprechend den zugeordneten Fehlerkorrekturcode-Prüfbits enthält.

**42.** Einrichtung nach einem der Ansprüche 19 bis 41, **dadurch gekennzeichnet, dass** die Testeinheit (18) einen Fehleradressen-Speicher (52) zum Speichern der Adressen mit fehlerhaften Speicherzellen enthält.

**43.** Einrichtung nach Anspruch 42, **dadurch gekennzeichnet, dass** auf Basis der im Fehleradressen-Speicher (52) gespeicherten Adressen die nachfolgenden Testläufe in vorgegebener Weise, z.B. durch Überspringen dieser Adressen, modifiziert werden.

**Claims**

**1.** A method for testing a memory (11), wherein data words (D) stored in memory cells (13) of the memory are read out cyclically from the memory (11) with associated check bits (EC) and examined for errors, **characterised in that** at memory accesses during the testing, the respective accessing address is compared with the address of the data word being tested, and **in that** at a write access, the data word to be written in is temporarily stored with the associated address and kept available for a possible read access while this associated address is compared with the address of the data word that is being tested.

2. A method according to claim 1, **characterised in that** the data word to be written is kept available with the associated address and the associated control signals until the actual writing into the memory (11).

3. A method according to claim 1 or 2, **characterised in that** at least one check bit (EC) is associated to the data word to be written when it is temporarily stored.

4. A method according to claim 3, **characterised in that** at least one parity check bit is associated to the data word to be written.

5. A method according to claim 3, **characterised in that** a Hamming Code check bit is associated to the data word to be written.

6. A method according to claim 3, **characterised in that** Hsiao Code check bits are associated to the data word to be written.

7. A method according to any one of claims 1 to 6, **characterised in that** all the memory cells (13), or stored data words (D) including their check bits (EC), contained in the memory (11) are consecutively tested in at least two test runs, e.g. according to a March test, and are each written back in inverted form into the memory (11).

8. A method according to claim 7 with any one of claims 3 to 6, **characterised in that** each data word (D) at first is checked for errors by means of its check bit(s) (EC) and subsequently a test is applied on word level to this data word.

9. A method according to claim 8, **characterised in that** the data word (D), after having been checked by means of the check bit(s) (EC), is written back into the memory (11) in completely inverted form and subsequently is read out again and checked for errors by comparison with the previously written, completely inverted data word ($\bar{D}$).

10. A method according to claim 8 or 9, **characterised in that** after having been checked by means of the check bit (s) (EC), the data word is written back into the memory (11) several times partially inverted and subsequently is read out again and checked for errors by comparison with the previously written, partially inverted data word, wherein the data word ($\bar{D}$) finally also is written into the memory (11) in completely inverted form, read back once more and compared with the last written, completely inverted data word.

11. A method according to claim 8 or 9, **characterised in that** after having been checked by means of the check bit (s), the data word (D) is written back into the memory (11) several times partially inverted, and subsequently is read out twice consecutively and checked for errors by comparison with the previously written, partially inverted data word, wherein the data word ($\bar{D}$) finally also is written into the memory (11) in completely inverted form, again is read back twice and each compared with the last written, completely inverted data word.

12. A method according to any one of claims 7 to 11 with claim 4, **characterised in that** after the test on word level has been effected, the interpretation of the parity check bit is each changed, the change being made from odd parity to even parity, and vice versa.

13. A method according to any one of claims 7 to 11 with claim 5, **characterised in that** after the test on word level has been effected, the respective interpretation of the Hamming Code check bits are changed, wherein for an even number of bits via which a Hamming Code check bit is computed, the change is made from odd parity to even parity, and vice versa, whereas for an odd number of bits via which a Hamming Code check bit is computed, the interpretation remains unchanged.

14. A method according to any one of claims 7 to 13, **characterised in that** from a total of four test runs per test cycle, two consecutive test runs are carried out according to an ascending address sequence, and the two other consecutive test runs are carried out according to a descending address sequence.

15. A method according to any one of claims 7 to 14, **characterised in that** the optionally buffered data words to be written, inclusively their check bits, each are written into the memory (11) in inverted form if the access address corresponds to a memory cell (13) the contents of which is present in inverted form at this point of time.

16. A method according to any one of claims 1 to 15, **characterised in that** the start address for the next test cycle is changed after each test cycle.

17. A method according to claim 16, **characterised in that** from an incremental start address sequence, a Gray-coded start address sequence which optionally is readable from right to left is produced.

18. A method according to any one of claims 14 to 17, **characterised in that** after each test cycle, the ascending and descending address sequence is rotated by one bit.

19. A device for testing a memory (11) connected to an access unit (12), with a test unit (18) associated to the memory (11) for cyclically reading out and testing memory cells (13) of the memory (11), or of data words stored in the memory, **characterised in that** the test unit (18) comprises an address comparator (16) for comparing the address of the data word that is being tested with an access address in case a memory access occurs through the access unit (12) simultaneously with the test, and **in that** a buffer (19) is connected with the test unit (18) for the temporarily storing data to be written and of associated addresses, as well as, preferably, of control signals during the address comparison.

20. A device according to claim 19, **characterised in that** the buffer (19) is designed in two stages in order that the respective data word to be written inclusively address and control signals is kept available for a possible read access to the write address before or while it is written into the memory (11).

21. A device according to claim 20, **characterised in that** the possible read access to the data word to be written is effected via the test unit (18) connected to the two buffer stages (20, 21).

22. A device according to claim 20 or 21, **characterised in that** the two buffer stages (20, 21) each are formed by a register.

23. A device according to any one of claims 19 to 22, **characterised in that** a check bit generator (22) is associated to the buffer (19) for adding at least one check bit (EC) each to the data word to be written.

24. A device according to claim 23 with any one of claims 17 to 19, **characterised in that** the check bit generator (19) is arranged in the data path between the two buffer stages (20, 21).

25. A device according to claim 23 or 24, **characterised in that** the check bit generator (22) is designed for associating parity check bits to the respective data word.

26. A device according to claim 23 or 24, **characterised in that** the check bit generator (22) is designed for associating Hamming Code check bits to the respective data word.

27. A device according to claim 23 or 24, **characterised in that** the check bit generator (22) is designed for associating Hsiao Code check bits to the respective data word.

28. A device according to any one of claims 19 to 27, **characterised in that** the test unit (18) contains a test control block (33) with a test-run-state machine for several test runs per test cycle, an error-test-state machine and an error-handling-state machine.

29. A device according to claim 28, **characterised in that** all memory cells (13) of the memory (11) are read out in a pre-determined sequence in the various test runs and their contents, i.e. data words (D) and check bits (EC) each are tested as well as re-written back in inverted form.

30. A device according to claim 28, **characterised in that** each data word (D) at first is checked for errors by means of its check bit(s) (EC) and subsequently a test is applied on word level to this data word (D), the data word (D) being provided in the memory (11) in inverted form after completion of the test on word level.

31. A device according to claim 30, **characterised in that** the data word (D), after having been checked by means of the check bit(s) (EC), is written back into the memory (11) in completely inverted form and subsequently is read out again and checked for errors by comparison with the previously written, completely inverted data word ($\bar{D}$).

**32.** A device according to claim 30 or 31, **characterised in that** after having been checked by means of the check bit (s) (EC), the data word (D) is written back into the memory (11) several times partially inverted and subsequently is read out again and checked for errors by comparison with the previously written, partially inverted data word, wherein the data word ($\bar{D}$) finally also is written into the memory (11) in completely inverted form, read back once more and compared with the last written, completely inverted data word.

**33.** A device according to claim 30 or 31, **characterised in that** after having been checked by means of the check bit (s) (EC), the data word (D) is written back into the memory (11) several times partially inverted, and subsequently is read out twice consecutively and checked for errors by comparison with the previously written, partially inverted data word, wherein the data word ($\bar{D}$) finally also is written into the memory (11) in completely inverted form, again is read back twice and each compared with the last written, completely inverted data word.

**34.** A device according to any one of claims 28 to 33, **characterised in that** in the case of a parity check bit, after the test on word level has been effected, the respective interpretation of the parity check bit is changed, the change being made from odd parity to even parity, and vice versa.

**35.** A device according to any one of claims 28 to 33, **characterised in that** in the case of Hamming Code check bits, after the test on word level has been effected, the respective interpretation of the Hamming Code check bits is changed, wherein for an even number of bits via which a Hamming Code check bit is computed, the change is made from odd parity to even parity, and vice versa, whereas for an odd number of bits via which a Hamming Code check bit is computed, the interpretation remains unchanged.

**36.** A device according to any one of claims 28 to 35, **characterised in that** the test-run-state machine provides two consecutive test runs in an ascending address sequence, and two consecutive test runs in a descending address sequence.

**37.** A device according to any one of claims 29 to 36, **characterised in that** the buffer (19) is followed by an inverter (31) and by a multiplexer (30) also connected to the inverter (31) so as to write the respective data word to be written including its check bit(s) in inverted state, if its address corresponds to a memory cell the contents of which is present in inverted form at this point of time.

**38.** A device according to any one of claims 19 to 37, **characterised in that** the test unit (18) comprises a test address generator (43) with a start address generating stage and test address counter unit (44) and connected upstream of the address comparator (16).

**39.** A device according to claim 38, **characterised in that** from an incremental start address sequence, the start address generating stage unit (44) produces a Gray-coded start address sequence which optionally is readable from right to left.

**40.** A device according to any one of claims 19 to 39, **characterised in that** the test unit (18) contains rotating units (45, 46) which, after each test cycle, rotate the ascending and the descending address sequence by one bit, and with a rotated test address sequence, allow for a comparison of the address of the data word just tested with an access address at a possible memory access by the access unit (12).

**41.** A device according to any one of claims 19 to 40, **characterised in that** the test unit (18) contains an error correction unit (27) for correcting errors in the tested data words in accordance with the associated error-correcting-code check bits.

**42.** A device according to any one of claims 19 to 41, **characterised in that** the test unit (18) contains an error address memory (52) for storing addresses with faulty memory cells.

**43.** A device according to claim 42, **characterised in that** on the basis of addresses stored in the error address memory (52), the subsequent test runs are modified in a pre-determined manner, e.g. by skipping these addresses.

**Revendications**

1. Procédé pour tester une mémoire (11), dans lequel des mots de données (D) mémorisés dans des cellules de mémoire (13) de la mémoire sont, au moyen de bits de contrôle associés (EC), lus de manière cyclique dans la mémoire (11) et sont analysés pour détecter les défauts, **caractérisé en ce que**, lors des accès aux mémoires pendant les tests, l'adresse d'accès respective est comparée avec l'adresse du mot de données testé à ce moment là et **en ce que**, lors d'un accès d'écriture, le mot de données à inscrire fait l'objet d'une mémorisation intermédiaire avec l'adresse correspondante et est tenu à disposition pour un éventuel accès de lecture, tandis que cette adresse correspondante est comparée avec l'adresse du mot de données testé à ce moment là.

2. Procédé selon la revendication 1, **caractérisé en ce que** le mot de données à inscrire, avec l'adresse correspondante et les signaux de commande correspondants, est tenu à disposition jusqu'à l'inscription effective dans la mémoire (11).

3. Procédé selon la revendication 1 ou 2, **caractérisé en ce que**, lors de sa mémorisation intermédiaire, au moins un bit de contrôle (EC) est attribué au mot de données à inscrire.

4. Procédé selon la revendication 3, **caractérisé en ce qu'**au moins un bit de contrôle de parité est attribué au mot de données à inscrire.

5. Procédé selon la revendication 3, **caractérisé en ce que** des bits de contrôle en code Hamming sont attribués au mot de données à inscrire.

6. Procédé selon la revendication 3, **caractérisé en ce que** des bits de contrôle en code Hsiao sont attribués au mot de données à inscrire.

7. Procédé selon l'une quelconque des revendications 1 à 6, **caractérisé en ce que** toutes les cellules de mémoire (13) ou tous les mots de données mémorisés (D) contenus dans la mémoire (11), y compris les bits de contrôle (EC), sont testés les uns après les autres lors d'au moins deux séquences de test successives, par exemple selon un test March, et sont réinscrits dans la mémoire (11) respectivement dans une forme inversée.

8. Procédé selon la revendication 7 avec l'une quelconque des revendications 3 à 6, **caractérisé en ce que** chaque mot de données (D) est d'abord contrôlé à l'aide de son bit de contrôle (EC) ou de ses bits de contrôle pour détecter les défauts et qu'ensuite un test au niveau du mot est utilisé sur ce mot de données.

9. Procédé selon la revendication 8, **caractérisé en ce qu'**après le contrôle à l'aide du ou des bit(s) de contrôle (EC), le mot de données (D) est réinscrit dans la mémoire (11) en étant entièrement inversé et est ensuite à nouveau lu et contrôlé pour détecter les défauts par une comparaison avec le mot de données ($\bar{D}$) inscrit auparavant et entièrement inversé.

10. Procédé selon la revendication 8 ou 9, **caractérisé en ce qu'**après le contrôle à l'aide du ou des bit(s) de contrôle (EC), le mot de données (D) est réinscrit dans la mémoire (11) en étant plusieurs fois inversé partiellement et est ensuite à nouveau lu et contrôlé pour détecter les défauts par une comparaison avec le mot de données (D) inscrit auparavant et inversé partiellement, alors que le mot de données ($\bar{D}$) est inscrit en dernier lieu dans la mémoire (11) en étant également entièrement inversé, est à nouveau relu et est comparé avec le mot de données inscrit en dernier lieu et entièrement inversé.

11. Procédé selon la revendication 8 ou 9, **caractérisé en ce qu'**après le contrôle à l'aide du ou des bit(s) de contrôle (EC), le mot de données (D) est réinscrit dans la mémoire (11) en étant plusieurs fois inversé partiellement et est ensuite lu deux fois consécutivement puis est contrôlé pour détecter les défauts par une comparaison avec le mot de données inscrit auparavant et inversé partiellement, alors que le mot de données ($\bar{D}$) est en dernier lieu inscrit dans la mémoire (11) en étant également entièrement inversé, est encore relu deux fois et est comparé respectivement avec le mot de données inscrit en dernier lieu et entièrement inversé.

12. Procédé selon l'une quelconque des revendications 7 à 11 avec la revendication 4, **caractérisé en ce qu'**après que le test au niveau du mot ait été réalisé, l'interprétation du bit de contrôle de parité est respectivement modifiée, un changement d'une parité impaire à une parité paire et inversement ayant lieu.

13. Procédé selon l'une quelconque des revendications 7 à 11 avec la revendication 5, **caractérisé en ce que**, lorsque le test au niveau du mot a été réalisé, l'interprétation des bits de contrôle en code Hamming est respectivement modifiée, alors que pour un nombre pair de bits, par l'intermédiaire desquels un bit de contrôle en code Hamming est calculé, un changement d'une parité impaire à une parité paire et inversement a lieu et alors que par contre pour un nombre impair de bits, par l'intermédiaire desquels un bit de contrôle en code Hamming est calculé, l'interprétation reste inchangée.

14. Procédé selon l'une quelconque des revendications 7 à 13, **caractérisé en ce que**, sur un total de quatre séquences de test par cycle de test, deux séquences de test successives sont réalisées selon une suite d'adresses croissante et les deux autres séquences de test successives sont réalisées selon une suite d'adresses décroissante.

15. Procédé selon l'une quelconque des revendications 7 à 14, **caractérisé en ce que** les mots de données à inscrire et faisant éventuellement l'objet d'une mémorisation intermédiaire, y compris les bits de contrôle, sont inscrits respectivement dans une forme inverse dans la mémoire (11) lorsque l'adresse d'accès correspond à une cellule de mémoire (13) dont le contenu existe sous une forme inversée à ce moment là.

16. Procédé selon l'une quelconque des revendications 1 à 15, **caractérisé en ce qu'**après chaque cycle de test, l'adresse de démarrage est modifiée pour le cycle de test suivant.

17. Procédé selon la revendication 16, **caractérisé en ce qu'**à partir d'une suite incrémentielle d'adresses de démarrage est générée une suite d'adresses de démarrage à codage Gray qui doit éventuellement être lue de la droite vers la gauche.

18. Procédé selon l'une quelconque des revendications 14 à 17, **caractérisé en ce qu'**après chaque cycle de test, la suite d'adresses montante et descendante est tournée d'un bit.

19. Dispositif pour tester une mémoire (11) reliée à une unité d'accès (12), avec une unité de test (18) associée à la mémoire (11) pour la lecture et le test cycliques de cellules de mémoire (13) de la mémoire (11) ou de mots de données mémorisés dans la mémoire, **caractérisé en ce que** l'unité de test (18) comprend un comparateur d'adresses (16) pour la comparaison de l'adresse du mot de données testé à ce moment-là avec une adresse d'accès dans le cas d'un accès à la mémoire par l'unité d'accès (12) ayant lieu en même temps que le test et **en ce qu'**à l'unité de test (18) est reliée une mémoire intermédiaire (19) servant à la mémorisation intermédiaire, lors de la comparaison des adresses, de données et d'adresses correspondantes à inscrire ainsi que de préférence de signaux de commande.

20. Dispositif selon la revendication 19, **caractérisé en ce que** la mémoire intermédiaire (19) est réalisée avec deux niveaux pour garder disponible chaque mot de données à inscrire y compris l'adresse et les signaux de commande, pour un éventuel accès en lecture à l'adresse d'écriture avant ou pendant l'écriture dans la mémoire (11).

21. Dispositif selon la revendication 20, **caractérisé en ce que** l'éventuel accès en lecture au mot de données à inscrire a lieu par l'intermédiaire de l'unité de test (18) reliée avec les deux niveaux de mémoire intermédiaire (20, 21).

22. Dispositif selon la revendication 20 ou 21, **caractérisé en ce que** les deux niveaux de mémoire intermédiaire (20, 21) sont respectivement formés par un registre.

23. Dispositif selon l'une quelconque des revendications 19 à 22, **caractérisé en ce qu'**à la mémoire intermédiaire (19) est attribué un générateur de bits de contrôle (22) pour rajouter respectivement au moins un bit de contrôle (EC) au mot de données à inscrire.

24. Dispositif selon la revendication 23 avec l'une quelconque des revendications 17 à 19, **caractérisé en ce que** le générateur de bits de contrôle (22) est disposé dans le trajet des données entre les deux niveaux de mémoire intermédiaire (20,21).

25. Dispositif selon la revendication 23 ou 24, **caractérisé en ce que** le générateur de bits de contrôle (22) est configuré pour l'attribution de bits de contrôle de parité au mot de données respectif.

**26.** Dispositif selon la revendication 23 ou 24, **caractérisé en ce que** le générateur de bits de contrôle (22) est configuré pour l'attribution de bits de contrôle en code Hamming au mot de données respectif.

**27.** Dispositif selon la revendication 23 ou 24, **caractérisé en ce que** le générateur de bits de contrôle (22) est configuré pour l'attribution de bits de contrôle en code Hsiao au mot de données respectif.

**28.** Dispositif selon l'une quelconque des revendications 19 à 27, **caractérisé en ce que** l'unité de test (18) contient un bloc de contrôle de test (33) avec une machine d'état de séquence de test pour plusieurs séquences de test par cycle de test, une machine d'état de tests de défauts et une machine d'état de traitement de défauts.

**29.** Dispositif selon la revendication 28, **caractérisé en ce que** toutes les cellules de mémoire (13) de la mémoire (11) sont lues lors de différentes séquences de test selon une chronologie imposée et **en ce que** leurs contenus, c'est-à-dire les mots de données (D) et les bits de contrôle (EC), sont respectivement testés et sont réinscrits dans une forme inverse.

**30.** Dispositif selon la revendication 28, **caractérisé en ce que** chaque mot de données (D) est d'abord contrôlé pour détecter les défauts à l'aide de son ou de ses bit(s) de contrôle (EC) et qu'ensuite un test au niveau du mot est utilisé sur ce mot de données (D), le mot de données (D) étant ensuite disponible sous une forme inversée dans la mémoire (11) lorsque le test au niveau du mot est terminé.

**31.** Dispositif selon la revendication 30, **caractérisé en ce qu'**après le contrôle à l'aide du ou des bit(s) de contrôle (EC), le mot de données (D) est réinscrit dans la mémoire (11) en étant entièrement inversé et est ensuite à nouveau lu et contrôlé pour détecter les défauts par une comparaison avec le mot de données (D) inscrit auparavant et entièrement inversé.

**32.** Dispositif selon la revendication 30 ou 31, **caractérisé en ce qu'**après le contrôle à l'aide du ou des bit(s) de contrôle (EC), le mot de données (D) est réinscrit dans la mémoire (11) en étant plusieurs fois partiellement inversé et est ensuite à nouveau lu et contrôlé pour détecter les défauts par une comparaison avec le mot de données (D) inscrit auparavant et partiellement inversé, alors que le mot de données ($\bar{D}$) est inscrit en dernier lieu dans la mémoire (11) en étant également entièrement inversé, est à nouveau relu et est comparé avec le mot de données inscrit en dernier lieu et entièrement inversé.

**33.** Dispositif selon la revendication 30 ou 31, **caractérisé en ce qu'**après le contrôle à l'aide du ou des bit(s) de contrôle (EC), le mot de données (D) est réinscrit dans la mémoire (11) en étant plusieurs fois inversé partiellement et est ensuite lu deux fois consécutivement puis est contrôlé pour détecter les défauts par une comparaison avec le mot de données inscrit auparavant et inversé partiellement, alors que le mot de données ($\bar{D}$) est en dernier lieu inscrit dans la mémoire (11) en étant également entièrement inversé, est encore relu deux fois et est comparé respectivement avec le mot de données inscrit en dernier lieu et entièrement inversé.

**34.** Dispositif selon l'une quelconque des revendications 28 à 33, **caractérisé en ce que**, dans le cas d'un bit de contrôle de parité, après que le test au niveau du mot ait été réalisé, l'interprétation du bit de contrôle de parité est respectivement modifiée, un changement d'une parité impaire à une parité paire et inversement ayant lieu.

**35.** Dispositif selon l'une quelconque des revendications 28 à 33, **caractérisé en ce que**, dans le cas de bits de contrôle en code Hamming, après la réalisation du test au niveau du mot, l'interprétation des bits de contrôle en code Hamming est respectivement modifiée, alors que pour un nombre pair de bits, par l'intermédiaire desquels un bit de contrôle en code Hamming est calculé, un changement d'une parité impaire à une parité paire et inversement a lieu et alors que par contre pour un nombre impair de bits, par l'intermédiaire desquels un bit de contrôle en code Hamming est calculé, l'interprétation reste inchangée.

**36.** Dispositif selon l'une quelconque des revendications 28 à 35, **caractérisé en ce que** la machine d'état de séquence de test prévoit deux séquences de test successives dans une suite d'adresses montante et deux séquences de test successives dans une suite d'adresses descendante.

**37.** Dispositif selon l'une quelconque des revendications 29 à 36, **caractérisé en ce que** la mémoire intermédiaire (19) est suivie d'un inverseur (31) et d'un multiplexeur (30) également relié avec l'inverseur (31) pour inscrire dans l'état inversé le mot de données respectif à inscrire, y compris le ou les bit(s) de contrôle, lorsque son adresse correspond à une cellule de mémoire dont le contenu est disponible sous une forme inversée à ce moment-là.

**38.** Dispositif selon l'une quelconque des revendications 19 à 37, **caractérisé en ce que** l'unité de test (18) comprend un générateur d'adresses de test (43) avec une unité (44) à seuils de production d'adresses de démarrage et de comptage d'adresses de test placé en amont du comparateur d'adresses (16).

**39.** Dispositif selon la revendication 38, **caractérisé en ce que** l'unité à seuils de production d'adresses de démarrage (44) génère à partir d'une suite incrémentielle d'adresses de démarrage une suite d'adresses de démarrage à codage Gray qui doit éventuellement être lue de la droite vers la gauche.

**40.** Dispositif selon l'une quelconque des revendications 19 à 39, **caractérisé en ce que** l'unité de test (18) contient des unités de mise en rotation (45, 46), qui font tourner d'un bit la suite d'adresses montante et la suite d'adresses descendante après chaque cycle de test et qui permettent, dans le cas d'une suite d'adresses de test ayant été tournée, une comparaison de l'adresse du mot de données qui vient d'être testée avec une adresse d'accès dans le cas d'un éventuel accès à la mémoire par l'intermédiaire de l'unité d'accès (12).

**41.** Dispositif selon l'une quelconque des revendications 19 à 40, **caractérisé en ce que** l'unité de test (18) comprend une unité de correction de défauts (27) pour la correction, selon les bits de contrôle des codes de correction de défauts qui ont été attribués, de défauts dans les mots de données testés.

**42.** Dispositif selon l'une quelconque des revendications 19 à 41, **caractérisé en ce que** l'unité de test (18) comprend une mémoire d'adresses de défauts (52) pour la mémorisation des adresses ayant des cellules de mémoire défectueuses.

**43.** Dispositif selon la revendication 42, **caractérisé en ce que**, sur la base des adresses mémorisées dans la mémoire d'adresses de défauts (52), les séquences de test suivantes sont modifiées de la manière imposée, par exemple par un franchissement de ces adresses.

FIG. 1

FIG. 2

FIG. 3

FIG. 4

FIG. 5

FIG. 10

FIG. 6

FIG. 7

FIG. 8

FIG. 9

FIG. 11

FIG. 12

FIG. 13

Reset oder Shutdown

March Standby

Start

RFirst

nächstes Wort

RLast 2

alle Bits invertiert

W

RLast

R

R 2

Write Back

Stopp oder Fehler gefunden

FIG. 14

Reset

NoErr

korrigierbarer Fehler

WCorrErr

Korrektur
erfolgreich

Fehler

weiterer Fehler

Status gelesen

WClrErr

RCorrErr

Korrektur erfolglos
(Korrektur erfolgreich)

# FIG. 15